(19) Europäisches Patentamt
European Patent Office
Office européen des brevets

(11) **EP 4 318 657 A1**

(12) **EUROPEAN PATENT APPLICATION**
published in accordance with Art. 153(4) EPC

(43) Date of publication:
**07.02.2024 Bulletin 2024/06**

(21) Application number: **22938765.9**

(22) Date of filing: **25.05.2022**

(51) International Patent Classification (IPC):
**H01M 4/38** (2006.01)

(86) International application number:
**PCT/CN2022/094848**

(87) International publication number:
**WO 2023/225884 (30.11.2023 Gazette 2023/48)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Contemporary Amperex Technology
Co., Limited
Ningde City, Fujian 352100 (CN)**

(72) Inventors:
• **DENG, Jingxian
Ningde, Fujian 352100 (CN)**
• **WANG, Jiazheng
Ningde, Fujian 352100 (CN)**

(74) Representative: **Kraus & Lederer
Patentanwälte PartGmbB
Thomas-Wimmer-Ring 15
80539 München (DE)**

(54) **NEGATIVE ELECTRODE ACTIVE MATERIAL, PREPARATION METHOD THEREFOR, AND DEVICE COMPRISING NEGATIVE ELECTRODE ACTIVE MATERIAL**

(57) The present application provides a negative electrode active material, a method preparing the same, and a device comprising the same. The negative electrode active material includes a carbon-silicon composite, which includes carbon-based particles and silicon nanoparticles, wherein the carbon-based particles have a carbon skeleton; the silicon nanoparticles attach to the carbon skeleton of carbon-based particles, and in the peripheral area of the carbon-silicon composite, the mass percentage content of carbon element $A_1$ and silicon element $B_1$ satisfy $0.8 \leq B_1/A_1 \leq 2.5$. When the negative electrode active material of the present application is applied to a secondary battery, during the cycling process of the secondary battery, the carbon-based particles can significantly limit the volume expansion of silicon nanoparticles, so as to improve the structural stability of the negative electrode active material and improve the cycling performance of the secondary battery.

**Figure 4**

EP 4 318 657 A1

**Description**

**Technical Field**

The present application relates to the field of batteries, specifically to a negative electrode active material and its preparation method, as well as a device comprising negative electrode active materials.

**Backgrounds**

The secondary battery has the characteristics of high capacity and long service life, so it is widely used in electronic equipment, such as mobile phones, laptops, battery cars, electric vehicles, Electric aircraft, electric boats, electric toy cars, electric toy boats, electric toy planes and electric tools. Due to the significant progress made in secondary batteries, higher requirements have been put forward for the performance of secondary batteries. In order to improve the performance of secondary batteries, materials such as negative electrode active materials are usually optimized and improved. Negative electrode active materials, as carriers of metal ions and electrons in secondary batteries, play a role in energy storage and release, and have an undeniable impact on the performance of secondary batteries.
Nevertheless, the improved negative electrode active material still has poor cycling and rate performance when applied to secondary batteries.

**Summary of the Invention**

The present application is based on the above topic, with the aim of providing a negative electrode active material and its preparation method, as well as a device containing negative electrode active material.
The first aspect of the present application provides a negative electrode active material for secondary batteries, which comprises a carbon-silicon composite, a carbon-silicon composite comprising carbon-based particles and silicon nanoparticles; wherein the carbon-based particles have a carbon skeleton; the silicon nanoparticles are attached to the carbon skeleton of the carbon-based particles, and wherein, in the peripheral area of the carbon-silicon composite, the mass percentage $A_1$ of carbon element in the carbon-silicon composite relative to the total mass of the carbon-silicon composite and the mass percentage $B_1$ of the silicon element in the carbon-silicon composite relative to the total mass of the carbon-silicon composite satisfy $0.8 \leq B_1/A_1 \leq 2.5$, and optionally, $1 \leq B1/A1 \leq 1.5$, wherein, the peripheral area of the carbon-silicon composite is an area extending within r/2 from the outer surface of the carbon-silicon composite towards the interior of the carbon-silicon composite, wherein r represents the short diameter of the carbon-silicon composite..
Therefore, when the negative electrode active material of the present application is applied to a secondary battery, during the cycling process of the secondary battery, silicon nanoparticles may experience volume expansion. Due to the adhesion of silicon nanoparticles to the carbon skeleton, the carbon skeleton has a certain inhibitory effect on the expansion of silicon nanoparticles, especially when the peripheral area of the carbon-silicon composite satisfys $0.8 \leq B_1/A_1 \leq 2.5$, silicon nanoparticles are more evenly attached to the carbon skeleton, carbon-based particles can significantly limit the volume expansion of silicon nanoparticles, thereby improving the structural stability of negative electrode active materials and thereby improving the cycling performance of secondary batteries. Due to the relatively high specific capacity of silicon nanoparticles, the capacity of negative electrode active materials can be increased, and the voltage of metal ion insertion is low, which is conducive to the insertion of metal ions, thereby improving the rate performance of secondary batteries. Due to the good conductivity of carbon-based particles, the conductivity of negative electrode active materials can be improved.
In some embodiments, in the central area of the carbon silicon complex, the mass percent content $A_2$ of the carbon element of the carbon silicon complex relative to the total mass of the carbon silicon complex and the mass percent content $B_2$ of the silicon element of the carbon silicon complex relative to the total mass of the carbon silicon complex satisfy $1.05 \leq A_2/B_2 \leq 50$, optionally, $1.05 \leq A_2/B_2 \leq 3$, wherein, the central area of the carbon silicon complex is the area within r/2 from the Centroid of the carbon silicon complex.
Therefore, the central area of the silicon carbon composite in the present application satisfys the requirements of $1.05 \leq A_2/B_2 \leq 50$, which can further improve the uniformity of the adhesion of silicon nanoparticles on the carbon skeleton, thereby further improving the structural stability of the negative electrode active material.
In some embodiments, the mass percentage content A of the carbon element of the carbon silicon complex relative to the total mass of the carbon silicon complex has a decreasing trend along the direction from the Centroid of the carbon silicon complex to the outer surface of the carbon silicon complex, and the mass percentage content B of the silicon element of the carbon silicon complex relative to the total mass of the carbon silicon complex has an increasing trend along the direction from the centroid of the carbon silicon complex to the outer surface of the carbon silicon complex.
As a result, the content of silicon nanoparticles attached to the carbon skeleton in the present application gradually increases, and the content of silicon nanoparticles is relatively high, which can significantly improve the capacity of the negative electrode active material.

In some embodiments, the mass percentage A of the carbon element in the carbon-silicon composite relative to the total mass of the carbon-silicon composite and the mass percentage B of the silicon element in the carbon-silicon composite relative to the total mass of the carbon-silicon composite also satisfy the following requirements: $1 \leq A/B \leq 3$, and further optionally, $1.3 \leq A/B \leq 2$.

Therefore, when the content of silicon nanoparticles attached to the carbon skeleton in the present application satisfys the above range, the content of silicon nanoparticles is relatively high, which can significantly improve the capacity of the negative electrode active material. The moderate content of carbon-based particles can improve the conductivity of negative electrode active materials.

In some embodiments, the carbon-based particles include one or more of graphite, soft carbon, and hard carbon. This type of carbon matrix particle provides a carbon skeleton structure, providing an adhesion basis for silicon nanoparticles.

In some embodiments, the carbon skeleton is a porous carbon skeleton, with silicon nanoparticles located in the pores and/or surfaces of the porous carbon skeleton.

Therefore, in the present application, at least some silicon nanoparticles are attached to the pores of the porous carbon skeleton. During the cycling process of the secondary battery, the porous carbon skeleton will to some extent limit the volume expansion of the silicon nanoparticles in its pores, thereby limiting the volume expansion of the silicon nanoparticles to a certain range, ensuring the structural stability of the negative electrode active material, and thereby improving the cycling performance of the secondary battery.

In some embodiments, the porous carbon skeleton includes pores that run through the carbon skeleton.

In some embodiments, the pore size of the hole ranges from 1nm to 200nm; Optionally, the pore size of the hole ranges from 1nm to 50nm. The pores within the pore size range are conducive to the attachment of silicon nanoparticles, and can effectively limit the volume expansion of silicon nanoparticles attached to the pores, and the silicon nanoparticles after volume expansion will basically not cause damage to the porous carbon skeleton, thus ensuring the structural stability of the porous carbon skeleton.

In some embodiments, the porosity of the porous carbon skeleton ranges from 40% to 70%; Optionally, the porosity of the porous carbon skeleton is from 50% to 60%. When the porosity of the porous carbon skeleton satisfys the above range, the volume occupied by the pores in the porous carbon skeleton is relatively high. Silicon nanoparticles adhere to the pores, and silicon nanoparticles and carbon-based particles can synergistically play a role, thereby improving the capacity and conductivity of the negative electrode active material.

In some embodiments, the particle size D of silicon nanoparticles satisfys $D \leq 10nm$. The particle size D of silicon nanoparticles is relatively small, which is more conducive to adhering to the surface and/or pores of the carbon skeleton, and their distribution is more uniform, which is conducive to improving the overall performance uniformity of the negative electrode active material.

In some embodiments, the negative electrode active material also includes a conductive layer coated with a carbon-silicon composite. As a continuous layered structure, the conductive layer is coated on the surface of the carbon-silicon composite, which can cover the pores on the surface of the silicon carbon composite, reduce the specific surface area of the silicon carbon composite, reduce the risk of side reactions between the silicon carbon composite and the electrolyte, and thus improve the structural stability of the silicon carbon composite. And the above substances have excellent conductivity, which can significantly improve the conductivity of negative electrode active materials.

In some embodiments, the thickness of the conductive layer satisfys $\leq 3.5 \ \mu m$. Optionally, the thickness of the conductive layer is from $2.5 \ \mu m$ to $3.3 \ \mu m$. When the thickness of the conductive layer satisfys the above range, it can improve the overall conductivity of the negative electrode active material. And it can ensure the smooth migration of metal ions in the negative electrode active material.

In some embodiments, the conductive layer includes a carbon layer and/or a conductive polymer layer; optionally, the conductive polymer layer includes one or more of polyaniline, polypyrrole, polyacetylene, polythiophene, polyphenylene sulfide and polyparaphenylene. The carbon layer is conducive to evenly dispersing on the surface of the silicon carbon composite, thereby improving the overall conductivity of the silicon carbon composite. The binding force between the conductive polymer layer and the silicon carbon composite is strong, making it difficult to peel off from the silicon carbon composite, thereby improving the structural stability of the negative electrode active material; and it can further improve the conductivity of the negative electrode active material.

In some embodiments, the average particle size Dv50 of the negative electrode active material satisfies $5 \ \mu m \leq Dv50 \leq 11 \ \mu m$. When the average particle size Dv50 of the highly active material satisfys the above range, the structure of the negative electrode active material is relatively stable and the kinetic performance is relatively good, which is conducive to improving the initial coulombic efficiency of the negative electrode active material.

In some embodiments, the average particle sizes Dv90, Dv10, and Dv50 of the negative electrode active material satisfy the following requirements: (Dv90 Dv10)/Dv50 ≤ 1.4. When the particle size distribution of the negative electrode active material satisfys the above range, the overall average particle size of the negative electrode active material is relatively moderate, and the particle size distribution is relatively average, which is conducive to improving the overall performance uniformity of the negative electrode active material.

In some embodiments, the specific surface area BET of the negative electrode active material satisfies BET ≤ 4 $m^2$/g. When the specific surface area BET of the negative electrode active material satisfys the above range, the range of specific surface area is relatively moderate, and the dynamic performance of the negative electrode active material is good, which is conducive to the initial coulombic efficiency of the negative electrode active material.

The second aspect of the present application provides a method for preparing negative electrode active materials, which includes: S100, providing a gas containing a silicon precursor to a carbon matrix particle having a carbon skeleton; S200, generating silicon nanoparticles attached to the carbon skeleton from silicon precursors by chemical vapor deposition,, resulting in a carbon-silicon composite. In the central area of the carbon-silicon composite, the mass percentage of carbon element in the carbon-silicon composite relative to the total mass of the carbon-silicon composite is A2, and the mass percentage of silicon element in the carbon-silicon composite relative to the total mass of the carbon-silicon composite is B2, which satisfys $1.05 \leq A_2/B_2 \leq 50$. Optionally, $1.05 \leq A_2/B_2 \leq 3$, The central area of the carbon silicon complex is the area within r/2 from the Centroid of the carbon silicon complex, and r represents the short diameter of the carbon silicon complex; In the peripheral area of the carbon-silicon composite, the mass percentage A1 of carbon element relative to the total mass of the carbon-silicon composite and the mass percentage B1 of silicon element relative to the total mass of the carbon-silicon composite satisfy the requirements of $0.8 \leq B_1/A_1 \leq 2.5$. Optionally, $1 \leq B_1/A_1 \leq 1.5$. Among them, the peripheral area of the carbon-silicon composite is an area extending within r/2 from the exterior of the carbon-silicon composite to the interior of the carbon-silicon composite.

Therefore, the method of the present application embodiment has a simple preparation process and convenient adjustment of process conditions; and when the prepared negative electrode active material is applied to the secondary battery, the cycling performance of the secondary battery is good.

In some embodiments, the method may also include: S300, forming a conductive layer on a silicon carbon composite. By forming a conductive layer on the surface of the silicon carbon composite, the silicon carbon composite is coated to improve the overall conductivity of the negative electrode active material.

The third aspect of the present application also provides a secondary battery, including a negative electrode active material in any embodiment of the first aspect of the present application or a negative electrode active material prepared in any embodiment of the second aspect of the present application.

The fourth aspect of the present application also provides a battery module, including a secondary battery according to the embodiment of the third aspect of the present application.

The fifth aspect of the present application also provides a battery pack, including a battery module according to the embodiment of the fourth aspect of the present application.

The sixth aspect of the present application also provides an electrical device, including a secondary battery according to the third aspect of the present application, a battery module according to the fourth aspect of the present application, or a battery pack according to the fifth aspect of the present application.

**Brief Description of the Drawing**

In order to provide a clearer explanation of the technical solution of the embodiments of the present application, a brief introduction will be given to the accompanying drawings required in the embodiments of the present application. It is evident that the accompanying drawings described below are only some embodiments of the present application. For ordinary technical personnel in the art, other accompanying drawings can be obtained based on the drawings without any creative effort.

Figure 1 is a schematic diagram of the process for preparing a negative electrode active material according to the first embodiment of the present application;

Figure 2 is a schematic diagram of the process for preparing negative electrode active materials in another embodiment of the present application;

Figure 3 is a schematic diagram of the process for preparing negative electrode active materials according to another embodiment of the present application;

Figure 4 is a schematic diagram of a secondary battery according to the first embodiment of the present application;

Figure 5 is an exploded view of the secondary battery according to the first embodiment of the present application as shown in Figure 4;

Figure 6 is a schematic diagram of a battery module according to an embodiment of the present application;

Figure 7 is a schematic diagram of a battery pack according to an embodiment of the present application;

Figure 8 is an exploded view of the battery pack according to an embodiment of the present application as shown in Figure 7;

Figure 9 is a schematic diagram of an electrical device according to an embodiment of the present application;

In the figures, the refernces are specified as follows:
1. Secondary battery; 11. Outer packaging; 111. Top cover component; 112. Shell; 12. Electrode assembly; 10. Battery module; 20. Battery pack; 21. Upper box; 22. Lower box; 30. Electrical equipment.

**Detailed Description**

The following provides a detailed explanation of the implementation methods of the electrolyte, secondary battery, battery, and electrical device disclosed in the present application. However, there may be situations where unnecessary detailed explanations may be omitted. For example, there are situations where detailed explanations of well-known matters are omitted and repeated explanations of the same structure are actually provided. This is to avoid the following explanations becoming unnecessarily lengthy and easy for those skilled in the art to understand. In addition, the accompanying drawings and the following explanations are provided for those skilled in the art to fully understand the present application and are not intended to limit the subject matter recorded in the claims.

The "scope" disclosed in the present application is limited in the form of a lower limit and an upper limit. The given scope is limited by selecting a lower limit and an upper limit, and the selected lower limit and upper limit limit limit the boundary of the special scope. The range limited in this way can include or exclude end values, and can be arbitrarily combined, that is, any lower limit can be combined with any upper limit to form a range. For example, if a range of 60-120 and 80-110 is listed for specific parameters, it is also expected to be understood as a range of 60-110 and 80-120. In addition, if the minimum range values 1 and 2 are listed, and if the maximum range values 3, 4, and 5 are listed, the following ranges can all be expected: 1-3, 1-4, 1-5, 2-3, 2-4, and 2-5. In the present application, unless otherwise specified, the numerical range "a-b" represents an abbreviated representation of any combination of real numbers between a and b, where a and b are both real numbers. For example, the numerical range "0-5" indicates that all real numbers between "0-5" have been listed in this article, and "0-5" is only a shortened representation of these numerical combinations. In addition, when expressing an integer with a parameter of $\geq 2$, it is equivalent to disclosing that the parameter is, for example, integers 2, 3, 4, 5, 6, 7, 8, 9, 10, 11, 12, etc.

If there is no special explanation, all implementation methods and optional implementation methods of the present application can be combined to form new technical solutions. Unless otherwise specified, all technical features and optional technical features of the present application can be combined to form a new technical solution.

If there is no special explanation, all steps of the present application can be carried out in sequence or randomly, preferably in sequence. For example, the method includes steps (a) and (b), indicating that the method can include steps (a) and (b) that are sequentially performed, as well as steps (b) and (a) that are sequentially performed. For example, mentioning a method can also include step (c), indicating that step (c) can be added to the method in any order. For example, the method can include steps (a), (b), and (c), as well as steps (a), (c), and (b), and can also include steps (c), (a), and (b).

If there is no special explanation, the terms "including/comprising" mentioned in the present application indicate open or closed. For example, "including/comprising" can indicate that other components that are not listed can also be included or comprised, or only listed components can be included or comprised.

If not specifically stated, in the present application, the term 'or' is inclusive. For example, the phrase "A or B" means "A, B, or both A and B. More specifically, any of the following conditions satisfy the condition "A or B": A is true (or exists) and B is false (or does not exist); A is false (or non-existent) and B is true (or exists); Or both A and B are true (or present).

Negative electrode active material

Firstly, the present application proposes a negative electrode active material. The negative electrode active material includes a carbon-silicon composite, which includes carbon-based particles and silicon nanoparticles.

The carbon-based particles have a carbon skeleton, which can be a solid structure or a porous skeleton structure with pores.

In the present application, the hole represents a concave structure relative to the outer surface of the negative electrode active material and concave to the interior of the negative electrode active material, or a through-hole that runs through the negative electrode active material. The porous skeleton structure indicates that there are multiple pores within the negative electrode active material, and the multiple pores can be parallel and/or cross arranged. The composition of porous structures includes pore size, pore length, and pore size distribution. The pore size of the porous carbon skeleton of carbon-based particles includes micropores, mesopores, and macropores. Micropores refer to pores with a diameter less than approximately 2 nanometers. Mesopores refer to pores with diameters ranging from approximately 2 nanometers to approximately 5 nanometers. Macropores refer to pores with a diameter greater than 50 nanometers.

The particle size of silicon nanoparticles is at the nanoscale, and when formed on the carbon skeleton, silicon nanoparticles are more easily uniformly attached to the carbon skeleton.

When the carbon skeleton is a solid structure, silicon nanoparticles can adhere to at least part of the surface of the carbon skeleton; When the carbon skeleton is a porous structure, silicon nanoparticles can adhere to at least some of the surface and pores of the carbon skeleton, and silicon nanoparticles can basically fill all the pores of the carbon skeleton.

The combination of carbon-based particles and silicon nanoparticles forms a carbon-silicon composite, which may be irregularly shaped particles. In this case, the particle size can be characterized using the triaxial diameter characterization method. The specific characterization method is as follows: the length diameter l and short diameter r are measured on the plane projection of the carbon-silicon composite, and the thickness h of the carbon-silicon composite is measured in the vertical direction of the projection plane; It can also be understood that the silicon carbon complex is placed in a rectangular cuboid tangent to it. The long side of the rectangular cuboid is l, the short side is r, and the thickness is h, so as to reflect the actual size of the silicon carbon complex.

The silicon carbon complex includes the central area, peripheral region, and transition region between the central area and peripheral region. The central area can be understood as the region within r/2 from the Centroid of the silicon carbon complex. The peripheral area can be understood as the area extending within r/2 from the outer surface of the silicon carbon composite to the interior of the silicon carbon composite.

When the silicon carbon composite contains a concave structure relative to the surface of the silicon carbon composite, the surface of the concave structure in the present application is not used as the outer surface of the silicon carbon composite, but as the internal structure of the silicon carbon composite.

In the peripheral area of the silicon carbon composite, the adhesion of silicon nanoparticles is relatively high. The mass percentage of carbon element in the carbon-silicon composite relative to the total mass of the carbon-silicon composite, $A_1$, and the mass percentage of silicon element in the carbon-silicon composite relative to the total mass of the carbon-silicon composite, $B_1$, satisfy the requirements of $0.8 \leq B_1/A1 \leq 2.5$.

When $A_1$ and $B_1$ satisfy the above range, the mass of silicon nanoparticles attached to the carbon-based particles is relatively high, which can significantly improve the capacity of the negative electrode active material. Moreover, the voltage of metal ion insertion is low, which is conducive to the insertion of metal ions, thereby improving the rate performance of secondary batteries. Moreover, carbon-based particles can significantly limit the volume expansion of silicon nanoparticles, thereby improving the structural stability of negative electrode active materials and thereby improving the cycling performance of secondary batteries. Optionally, $1 \leq B_1/A_1 \leq 1.5$. For example, $B_1/A_1$ can be 0.8, 0.9, 1, 1.1, 1.2, 1.3, 1.4, 1.5, 1.6, 1.8, 1.9, 2.0, 2.1, 2.2, 2.3, 2.4, or 2.5; or a range composed of any two values mentioned above.

When applying the above negative electrode active materials to secondary batteries, silicon nanoparticles may experience volume expansion during the cycling process. Due to the adhesion of silicon nanoparticles to the carbon skeleton, the carbon skeleton has a certain inhibitory effect on the expansion of silicon nanoparticles. Especially when the peripheral area of the carbon-silicon composite satisfys $0.8 \leq B_1/A_1 \leq 2.5$, the carbon-based particles can significantly limit the volume expansion of silicon nanoparticles, Thus, the structural stability of the negative electrode active material can be improved, thereby improving the cycling performance of the secondary battery. Due to the relatively high specific capacity of silicon nanoparticles, the capacity of negative electrode active materials can be increased, and the voltage of metal ion insertion is low, which is conducive to the insertion of metal ions, thereby improving the rate performance of secondary batteries. Due to the good conductivity of carbon-based particles, the conductivity of negative electrode active materials can be improved.

In some embodiments, the adhesion of silicon nanoparticles to carbon-based particles exhibits a certain distribution trend. In the central area of the silicon carbon composite, the adhesion amount of silicon nanoparticles is relatively small, and the mass percentage content of carbon element in the carbon-silicon composite relative to the total mass of the carbon-silicon composite is $A_2$. The mass percentage content $B_2$ of silicon element in the carbon-silicon composite relative to the total mass of the carbon-silicon composite satisfys $1.05 \leq A_2/B_2 \leq 50$.

When $A_2$ and $B_2$ satisfy the above range, the mass of silicon nanoparticles attached to the carbon-based particles is relatively low. During the cycling process of the secondary battery, the carbon-based particles can effectively reduce the expansion of silicon nanoparticles, thereby improving the structural stability of the negative electrode active material and thereby improving the cycling performance of the secondary battery. With the decrease of $A_2/B_2$, the content of silicon nanoparticles attached to the carbon-based particles increases, which can improve the capacity of the negative electrode active material. Moreover, the voltage of metal ion insertion is lower, which is conducive to the insertion of metal ions, thereby improving the rate performance of secondary batteries. Optionally, $1.05 \leq A_2/B_2 <\_ 3$. For example, $A_2/B_2$ can be 1.05, 1.1, 1.15, 1.20, 1.25, 1.30, 1.40, 1.50, 1.60, 1.70, 1.80, 1.90, 2.0, 2.2, 2.5, 2.8, 3.0, 5, 10, 15, 20, 25, 30, 35, 40, 45, or 50; or a range composed of any two values mentioned above.

The central area of the silicon carbon composite in the present application satisfys the requirements of $1.05 \leq A_2/B_2 <\_ 50$, which can further improve the uniformity of the adhesion of silicon nanoparticles on the carbon skeleton, thereby further improving the structural stability of the negative electrode active material.

In some embodiments, the mass percentage content A of the carbon element of the carbon silicon complex relative to the total mass of the carbon silicon complex has a decreasing trend along the direction from the Centroid of the carbon silicon complex to the outer surface of the carbon silicon complex, and the mass percentage content B of the silicon element of the carbon silicon complex relative to the total mass of the carbon silicon complex has an increasing trend along the direction from the Centroid of the carbon silicon complex to the outer surface of the carbon silicon complex.

Since the silicon carbon complex may be an example of irregular shape, the centroid of the silicon carbon complex can be equal to the centroid of the rectangular cuboid tangent to it. From the centroid of the silicon carbon complex to the outer surface of the silicon carbon complex, the mass percent content A of carbon element gradually decreases, and the mass percent content B of silicon element gradually increases, that is, the content of silicon nanoparticles attached to the carbon skeleton gradually increases, and the content of silicon nanoparticles is relatively high, which can significantly improve the capacity of Negative electrode active materials.

Optionally, the mass percentage A of the carbon element in the carbon-silicon composite relative to the total mass of the carbon-silicon composite and the mass percentage B of the silicon element in the carbon-silicon composite relative to the total mass of the carbon-silicon composite also satisfy the following requirements: $1 \leq A/B \leq 3$, and further optionally, $1.3 \leq A/B \leq 2$. For example, A/B can be 1, 1.1, 1.2, 1.3, 1.4, 1.5, 1.6, 1.8, 2.0, 2.1, 2.2, 2.3, 2.5, 2.8, or 3; or a range composed of any two values mentioned above.

In some embodiments, the carbon-based particles include one or more of graphite, soft carbon, and hard carbon. For example, carbon-based particles may include hard carbon. This type of carbon matrix particle provides a carbon skeleton structure, providing an adhesion basis for silicon nanoparticles.

In some embodiments, the carbon skeleton can be a porous carbon skeleton. The porous carbon skeleton contains pores, and silicon nanoparticles can not only not adhere to the surface of the carbon skeleton, but also fill the pores. In other words, silicon nanoparticles are located in the pores and/or surface of the porous carbon skeleton.

When applying negative electrode active materials to secondary batteries, at least some silicon nanoparticles adhere to the pores of the porous carbon skeleton. During the cycling process of the secondary battery, the porous carbon skeleton will to some extent limit the volume expansion of silicon nanoparticles in its pores, thereby limiting the volume expansion of silicon nanoparticles to a certain range and ensuring the structural stability of the negative electrode active material, Further improve the cycling performance of the secondary battery.

In some embodiments, the porous carbon skeleton contains pores that run through the carbon skeleton, and silicon nanoparticles adhere to these pores, which facilitates the uniform adhesion of silicon nanoparticles to various regions of the porous carbon skeleton. The volume expansion of silicon in each region of the silicon carbon composite is basically consistent, thereby improving the uniformity of the performance of each region of the porous carbon skeleton and thereby improving the balance of the overall performance of the negative electrode active material.

In some embodiments, the pore diameter of the porous carbon skeleton is a nanometer pore diameter, and the pores within this pore diameter range are conducive to the attachment of silicon nanoparticles, and can effectively limit the volume expansion of silicon nanoparticles attached to the pores, and the silicon nanoparticles after volume expansion will not cause damage to the porous carbon skeleton, thus ensuring the structural stability of the porous carbon skeleton.

Optionally, the pore size of the porous carbon skeleton can be from 1nm to 200nm; Optionally, the pore size of the porous carbon skeleton can range from 1nm to 50nm. For example, the pore size of the porous carbon skeleton can be 1nm, 10nm, 20nm, 30nm, 40nm, 50nm, 60nm, 70nm, 80nm, 90nm, 100nm, 120nm, 150nm, 180nm or 200nm; or a range composed of any two values mentioned above.

In some embodiments, the porosity of the porous carbon skeleton ranges from 40% to 70%.

The porosity of a porous carbon skeleton refers to the ratio of the pore volume in the porous carbon skeleton to the total volume of the porous carbon skeleton.

When the porosity of the porous carbon skeleton satisfys the above range, the volume occupied by the pores in the porous carbon skeleton is relatively high. Silicon nanoparticles adhere to the pores, and silicon nanoparticles and carbon-based particles can synergistically play a role, thereby improving the capacity and conductivity of the negative electrode active material. Optionally, the porosity of the porous carbon skeleton can be between 50% and 60%; For example, the porosity of a porous carbon skeleton can be 40%, 42%, 45%, 48%, 50%, 52%, 55%, 58%, 60%, 62%, 65%, 68%, and 70%; or a range composed of any two values mentioned above.

In the present application, the introduction of porosity into carbon-based particles can be achieved in various ways, for example, the porosity in carbon-based particles can be achieved by adjusting processing conditions to generate a porous carbon skeleton.

In some embodiments, the particle size D of silicon nanoparticles satisfies the requirement of D ≤ 10nm.

The particle size D of silicon nanoparticles is relatively small, which is more conducive to adhering to the surface and/or pores of the carbon skeleton, and their distribution is more uniform, which is conducive to improving the overall performance uniformity of the negative electrode active material. For example, D can be 10nm, 8nm, 6nm, 5nm, 4nm, 3nm, 2nm, or 1nm.

In some embodiments, the negative electrode active material may also include a conductive layer coated with a carbon-silicon composite. The conductive layer is coated on the surface of the carbon-silicon composite, which is a continuous structure that can connect the discontinuous areas of the composite, thereby improving the overall conductivity of the negative electrode active material.

When the silicon carbon composite is a solid structure, the conductive layer is coated on the surface of the silicon carbon composite, thereby improving the overall conductivity of the negative electrode active material. When the silicon carbon composite contains a porous carbon skeleton, due to the filling of silicon nanoparticles in the pores of the porous carbon skeleton, the overall structure of the silicon carbon composite appears as a solid structure. The conductive layer covers the surface of the silicon carbon composite, making the surface of the negative electrode active material a continuous conductive surface, thereby improving the conductivity of the negative electrode active material.

In some embodiments, the conductive layer may include a carbon layer and/or a conductive polymer layer. As a continuous layered structure, the conductive layer is coated on the surface of the carbon-silicon composite, which can cover the pores on the surface of the silicon carbon composite, reduce the specific surface area of the silicon carbon composite, reduce the risk of side reactions between the silicon carbon composite and the electrolyte, and thus improve the structural stability of the silicon carbon composite. And the above substances have excellent conductivity, which can significantly improve the conductivity of negative electrode active materials.

As some examples, the carbon layer can include carbon particles, which have a smaller particle size and are conducive to uniform dispersion on the surface of the silicon carbon composite, thereby improving the overall conductivity of the silicon carbon composite.

As another example, the conductive polymer layer may include one or more of polyaniline, polypyrrole, polyacetylene, polythiophene, polyphenylene sulfide and polyparaphenylene. This type of conductive polymer layer has a strong binding force with silicon carbon composites, making it difficult to peel off from the silicon carbon composites, thereby improving the structural stability of negative electrode active materials; And it can further improve the conductivity of the negative electrode active material.

In some embodiments, the thickness of the conductive layer is ≤ 3.5 μm. Optionally, the thickness of the conductive layer is from 2.5 μm to 3.3 μm.

When the thickness of the conductive layer satisfys the above range, the overall conductivity of the negative electrode active material can be imporved; it can ensure the smooth migration of metal ions in the negative electrode active material. Optionally, the thickness of the conductive layer can be from 2.5 μm to 3.3 μm; For example, the thickness of the conductive layer can be 1 μm, 1.5 μm, 2.0 μm, 2.5 μm, 3 μm, 3.3 μm or 3.5 μm; or a range composed of any two values mentioned above.

In some embodiments, the average particle size Dv50 of the negative electrode active material satisfies 5 μm ≤ Dv50 ≤ 11 μm.

The Dv50 value of the negative electrode active material refers to the median particle size of the negative electrode active material. Specifically, a specific Dv50 value indicates that the diameter of particles accounting for 50% of the total volume is greater than this value, while another 50% of the total volume has a diameter smaller than this value. The Dv50 value of negative electrode active materials can be measured according to the method specified in GB/T19077-2016.

When the average particle size Dv50 of the negative electrode active material satisfys the above range, the structure of the negative electrode active material is relatively stable and the kinetic performance is relatively good, which is conducive to improving the initial coulombic efficiency of the negative electrode active material. For example, the average particle size Dv50 of the negative electrode active material can be 5 μm, 6 μm, 7 μm, 8 μm, 9 μm, 10 μm or 11 μm; Of course, it can also be a range composed of any two values mentioned above.

Optionally, the average particle sizes of the negative electrode active material Dv90, Dv10, and Dv50 satisfy the following requirements: (Dv90 Dv10)/Dv50 ≤ 1.4.

(Dv90 Dv10)/Dv50 represents the particle size distribution spin of the negative electrode active material.

Dv10 value of the negative electrode active material represents the particle size corresponding to 10% of the volume distribution in the particles, which specifically indicates that the particle diameter accounting for 10% of the total volume in the particles is greater than this value, and the particle diameter accounting for 90% of the total volume is less than this value. The Dv10 value of negative electrode active materials can be measured according to the method specified in GB/T19077-2016.

Dv90 value of the negative electrode active material represents the particle size corresponding to 90% of the volume distribution in the particles. The Dv90 value indicates that the particle diameter accounting for 90% of the total volume is greater than this value, and another 10% of the total volume has a particle diameter smaller than this value. The Dv90 value of negative electrode active materials can be measured according to the method specified in GB/T19077-2016.

When the particle size distribution of the negative electrode active material satisfys the above range, the overall average particle size of the negative electrode active material is relatively moderate, and the particle size distribution is relatively average, which is conducive to improving the overall performance uniformity of the negative electrode active material. For example, (Dv90 Dv10)/Dv50 can be 1.4, 1.3, 1.2, 1.1, 1, or 0.75; Of course, it can also be a range composed of any two values mentioned above. The present application can regulate the particle size distribution of the negative electrode active material by grinding multiple diameter ball milling beads together during the preparation process.

In some embodiments, the specific surface area BET of the negative electrode active material may satisfiy BET $\leq 4m^2/g$.

Specific surface area refers to the total specific surface area of a substance that can be measured using BET technology. The surface area is usually expressed in units of $m^2/g$. The BET (Brunauer/Emmett/Teller) technology uses inert gases (such as nitrogen) to measure the amount of gas adsorbed on the negative electrode active material, and is commonly used in this field to determine the accessible surface area of the material.

When the specific surface area BET of the negative electrode active material satisfys the above range, the range of specific surface area is relatively moderate, and the dynamic performance of the negative electrode active material is good, which is conducive to the initial coulombic efficiency of the negative electrode active material. For example, BET can be $4m^2/g$, $3.5m^2/g$, $3m^2/g$, $2.5m^2/g$, $2m^2/g$, $1.5m^2/g$, $1m^2/g$, or $0.75m^2/g$; Of course, it can also be a range composed of any two values mentioned above.

Method for preparing negative electrode active materials

In the second aspect, the present application also proposes a method for preparing negative electrode active materials, which can be used to prepare negative electrode active materials in any embodiment of the first aspect of the present application.

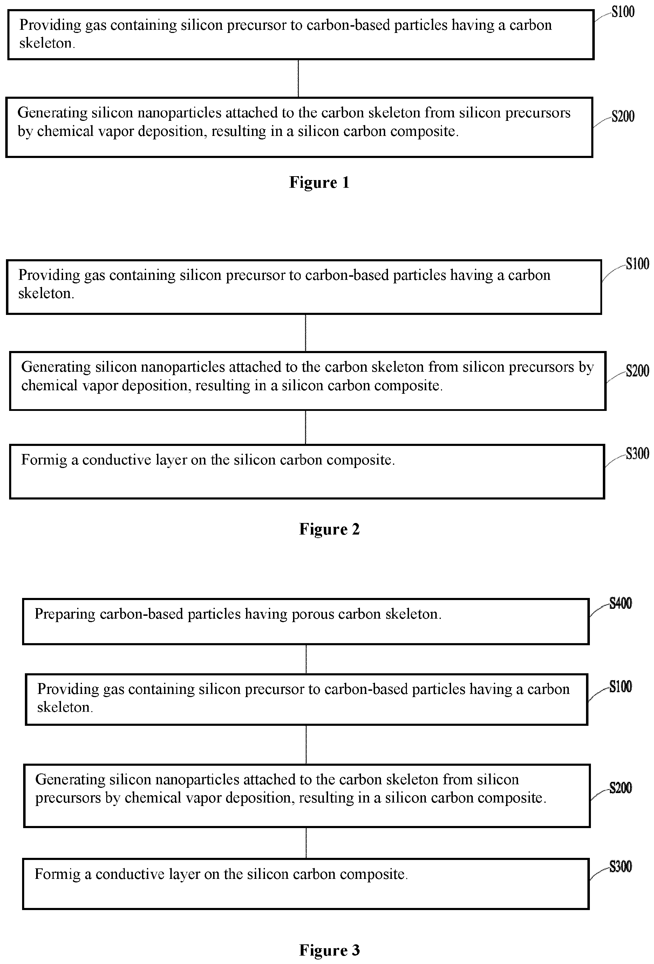

As shown in Figure 1, this method specifically includes:

S100, providing gas containing silicon precursor to carbon-based particles having a carbon skeleton.

S200, generating silicon nanoparticles attached to the carbon skeleton from silicon precursors by chemical vapor deposition, resulting in a silicon carbon composite.

The precursor of silicon is deposited on the carbon skeleton through chemical vapor deposition to form silicon nanoparticles, which composite the carbon-based particles and silicon nanoparticles into a silicon carbon composite. Carbon and silicon elements can work together to improve the conductivity and capacity of the negative electrode active material. On the basis of improving the conductivity and capacity of the negative electrode active material, carbon-based particles can to some extent limit the volume expansion of silicon nanoparticles, thereby ensuring the structural stability of the negative electrode active material.

Especially when the negative electrode active material satisfys the following requirements: in the peripheral area of the carbon-silicon composite, the mass percentage content of the carbon element in the carbon-silicon composite relative to the total mass of the carbon-silicon composite $A_1$ and the mass percentage content of the silicon element in the carbon-silicon composite relative to the total mass of the carbon-silicon composite $B_1$ satisfy $0.8 \leq B_1/A_1 \leq 2.5$, and optionally, $1 \leq B_1/A_1 \leq 1.5$; Carbon and silicon elements can better exert synergistic effects and improve the structural stability and capacity of negative electrode active materials.

In step S100, the carbon-based particles can be pre placed in the heating chamber of the vapor deposition furnace, and the heating chamber can be vacuumed using a vacuum pump. Inject protective gas into the heating chamber, and after the protective gas fills the heating chamber, introduce the gas containing the silicon precursor into the heating chamber and maintain a certain pressure in the heating chamber.

In the present application, inert gas and/or hydrogen gas can be used as the protective gas, and the protective gas and gas containing silicon precursor can be jointly input onto the carbon-based particles. For example, inert gases can include one or more of nitrogen, argon, and helium. By way of example, gases containing silicon precursors include one or more of silane, Dichlorosilane, tri Chlorosilane and tetra Chlorosilane.

In the present application, the deposition effect can be improved by controlling the deposition conditions, especially when the carbon-based particles contain a porous carbon skeleton. The uniformity of the deposition of silicon nanoparticles in the pores of the porous carbon skeleton can be adjusted, so that the porous carbon skeleton can better reduce the expansion volume of silicon nanoparticles and improve the cycling performance of the secondary battery. In addition, the silicon nanoparticles deposited on the porous carbon skeleton do not agglomerate, thus ensuring the cycling performance of the secondary battery.

In some embodiments, the airflow ratio of the gas containing the silicon precursor to the shielding gas can be (1-10): 1.

In some embodiments, the heating chamber heats up to 450 °C to 1000 °C, maintains insulation for 2 to 10 hours, and the pressure inside the furnace is positive.

In some embodiments, the heating chamber is vacuumed to a relative vacuum degree of 100Pa-800Pa, and has a rotary function, with a speed control of 0.5r/min-3r/min.

In S200, during the chemical vapor deposition process, the silicon precursor can be decomposed into silicon nanoparticles by heating and deposited on the carbon-based particles.

After the insulation of the heating chamber is completed, stop the introduction of gas containing silicon precursor, and after the formed silicon nanoparticles are naturally cooled, stop the introduction of protective gas. The carbon-silicon composite formed in step S200 can be used as the final product of the negative electrode active material. Of course, after step S200, other processes such as steps S510 and/or S300 can be carried out to further improve the performance of the negative electrode active material.

As shown in Figure 2, in some embodiments, the method for preparing negative electrode active materials also includes:

S300, formig a conductive layer on the silicon carbon composite.

The conductive layer can include a carbon layer and/or a conductive polymer layer. By forming a conductive layer on the surface of the silicon carbon composite, the silicon carbon composite is coated to improve the overall conductivity of the negative electrode active material.

The silicon carbon composite formed in step S300 can be used as the final product of the negative electrode active material. Of course, after step S300, other processes such as step S520 can be carried out to further improve the performance of the negative electrode active material.

As some examples, when forming a carbon layer, a carbon layer can be formed by chemical vapor deposition, using hydrocarbon gases as the carbon source to coat the surface of the silicon carbon composite. In some embodiments, hydrocarbon gases may include C1-C3 straight chain alkanes, Cyclopropane, C2-C3 alkenes, and C2-C3 alkynes. For example, C1-C3 straight chain alkanes can include one or more of methane, ethane, and propane. C2-C3 olefins can include ethylene and/or propylene. C2-C3 alkynes can include acetylene and/or acetylene.

The present application can form a carbon layer in a protective atmosphere; The protective gas can be nitrogen or argon.

The present application can improve the deposition effect by controlling the deposition conditions, covering the pores on the surface of the silicon carbon composite, reducing the specific surface area of the negative electrode active material, and improving the conductivity of the negative electrode active material.

In some embodiments, the airflow ratio of hydrocarbon gas to shielding gas is 1: (1.5-10).

In some embodiments, the temperature during the formation of the carbon layer is controlled between 750 °C and 950 °C; The coating time should be controlled between 2h and 8h.

As other examples, when forming a conductive polymer layer, the organic polymer can be dissolved in the solvent by solvent method, and then mixed evenly with the carbon-silicon composite to remove the solvent, so that the organic polymer forms a conductive polymer layer that covers the surface of the silicon carbon composite. By way of example, the organic polymer may include one or more of Polyaniline, Polypyrrole, Polyacetylene, Polythiophene, Polyphenylene sulfide and polyparaphenylene. Solvents can include acetone or methanol, etc. The present application can improve the coating effect by controlling the coating conditions, covering the pores on the surface of the silicon carbon composite, reducing the specific surface area of the negative electrode active material, and improving the conductivity of the negative electrode active material.

In some embodiments, the method for preparing negative electrode active materials also includes:

S500, screening the silicon carbon composite to separate negative electrode active materials that satisfy the preset particle size range.

The screening steps of step S500 can include step S510, which can be carried out after step S200.

S510, performing the first screening of silicon carbon complexes to separate silicon carbon complexes that satisfy the first preset particle size range. This step can remove the undeposited silicon nanoparticles. For example, the first preset particle size range can be Dv10 $\geq$ 1.5 $\mu$m. The first screening process can remove smaller silicon carbon composites, thereby making the particle size distribution of silicon carbon composites more uniform. The silicon carbon composite obtained after the first screening process can be used as the finished product of the negative electrode active material. Of course, after the first screening process, other processes such as step S300 can be continued to improve the performance of the negative electrode active material.

The filtering step of step S500 can also include step S520, which can be carried out after step S300.

S520, performing a second screening of the silicon carbon composite to separate the silicon carbon composite that satisfys the second preset particle size range. For example, the second preset particle size range can be 5 μm ≤ Dv50 ≤ 11 μm.

As shown in Figure 3, in some embodiments, the method for preparing negative electrode active materials also includes: S400, preparing carbon-based particles containing porous carbon frameworks; Specifically, the preparation process includes:

S410 using biomass as a carbon source to crush biomass, which can be used in one or more of coconut shells, bark, and fruit kernels.

S420, using mineral acid to clean the crushed biomass, wherein the mineral acid can be one or more of sulfuric acid, hydrochloric acid and hydrofluoric acid. The concentration of Mineral acid is 1mol/L-5mol/L, and the pickling time is from 0.5h to 2h.

S430, after acid washing, the biomass is first washed with deionized water to remove residual acid, and then pre-carbonized in an inert atmosphere. Inert gases can be one or more selected from the group consisting of nitrogen, argon, and helium. The pre-carbonization temperature is between 400 °C and 500 °C, and the pre carbonization time is between 2h and 5h.

S440, carbonizing the pre-carbonized biomass at high temperature to obtain porous carbon materials. The carbonization temperature is 800 °C-1600 °C, and the carbonization time is 2-4 hours.

After depositing silicon nanoparticles in the porous carbon skeleton, it is more advantageous for the porous carbon skeleton to limit the volume expansion of silicon nanoparticles, thereby ensuring the structural stability of the negative electrode active material.

The present application can adjust the pore size and porosity of the porous carbon skeleton by controlling at least one of the pickling concentration, pickling time, pre carbonization temperature, pre carbonization time, carbonization temperature, and carbonization time.

Secondary battery

Thirdly, the present application proposes a secondary battery. Secondary batteries can also include positive electrode plates, negative electrode plates, seperators, and electrolytes. The seperator is set between the positive and negative electrode plates to separate them.

[Negative electrode plate]

The negative electrode plate includes a negative current collector and a negative electrode active material layer arranged on at least one surface of the negative current collector, and the Negative electrode active material layer includes a negative electrode active material.

As an example, the negative current collector has two opposite surfaces in its own thickness direction, and the negative electrode active material layer is arranged on either or both of the opposite surfaces of the negative current collector.

In some embodiments, the negative current collector can use metal foil or composite current collector. For example, as a metal foil, copper foil can be used. The composite fluid collector can include a polymer material substrate and a metal layer formed on at least one surface of the polymer material substrate. Composite fluid collectors can be formed by forming metal materials (copper, copper alloys, nickel, nickel alloys, titanium, titanium alloys, silver, and silver alloys, etc.) onto polymer substrates such as polypropylene (PP), polyethylene terephthalate (PET), polybutylene terephthalate (PBT), polystyrene (PS), polyethylene (PE), etc.

In some embodiments, the negative electrode active material may include the negative electrode active material of any embodiment of the first aspect of the present application, or the negative electrode active material prepared by the method of any embodiment of the second aspect of the present application.

During the cycling process of the secondary battery in the present application, the carbon skeleton has a certain inhibitory effect on the expansion of silicon nanoparticles, especially when the peripheral area of the carbon-silicon composite satisfys $0.8 \leq B_1/A_1 \leq 2.5$, the carbon-based particles can significantly limit the volume expansion of silicon nanoparticles, thereby improving the structural stability of the negative electrode active material and thereby improving the cycling performance of the secondary battery. Due to the relatively high specific capacity of silicon nanoparticles, the capacity of negative electrode active materials can be increased, and the voltage of metal ion insertion is low, which is conducive to the insertion of metal ions, thereby improving the rate performance of secondary batteries. Due to the good conductivity of carbon-based particles, the conductivity of negative electrode active materials can be improved.

In some embodiments, the negative electrode active material layer may also optionally include an adhesive. The binder can be selected from at least one of Styrene-butadiene (SBR), polyacrylic acid (PAA), Sodium polyacrylate (PAAS), polyacrylamide (PAM), polyvinyl alcohol (PVA), sodium alginate (SA), polymethacrylic acid (PMAA) and carboxymethyl chitosan (CMCS).

In some embodiments, the negative electrode active material layer may also optionally include a conductive agent. The conductive agent can be selected from at least one of superconducting carbon, acetylene black, carbon black, Ketjen Black, carbon dots, carbon nanotubes, graphene and carbon nanofibers.

In some embodiments, the Negative electrode active material layer also optionally includes other additives, such as thickening agent (such as Carboxymethyl cellulose sodium (CMC-Na)) and the like.

In some embodiments, negative electrode plates can be prepared by dispersing the components used for preparing negative electrode plates, such as negative electrode active materials, conductive agents, binders, and any other components, into a solvent (such as deionized water) to form a negative electrode paste; After coating the negative electrode paste on the negative electrode current collector, drying, cold pressing, and other processes, the negative electrode plate can be obtained.

[Positive electrode plate]

The positive electrode plate includes a positive electrode current collector and a positive electrode active material layer arranged on at least one surface of the positive electrode current collector, and the positive electrode active material layer includes a positive electrode active material.

As an example, the positive electrode current collector has two opposite surfaces in its own thickness direction, and the positive electrode active material layer is arranged on either or both of the opposite surfaces of the positive electrode current collector.

In some embodiments, the positive electrpde current collector can use metal foil or composite current collector. For example, as a metal foil, aluminum foil can be used. The composite fluid collector can include a polymer material substrate and a metal layer formed on at least one surface of the polymer material substrate. Composite fluid collectors can be formed by forming metal materials (aluminum, aluminum alloys, nickel, nickel alloys, titanium, titanium alloys, silver, and silver alloys, etc.) onto polymer material substrates (such as polypropylene (PP), polyethylene terephthalate (PET), polybutylene terephthalate (PBT), polystyrene (PS), polyethylene (PE)).

In some embodiments, the positive electrode active material can be a positive electrode active material commonly known in the art for batteries. As an example, the positive active material can include at least one of the following materials: lithium phosphate with olivine structure, lithium Transition metal oxides and their respective modified compounds. However, the present application is not limited to these materials, and other traditional materials that can be used as positive electrode active materials for batteries can also be used. These positive electrode active materials can be used alone or in combination with two or more. Among them, examples of lithium Transition metal oxides can include but are not limited to lithium cobalt oxide (such as $LiCoO_2$), lithium nickel oxide (such as $LiNiO_2$), lithium manganese oxide (such as $LiMnO_2$, $LiMn_2O_4$), lithium nickel cobalt oxide, lithium manganese cobalt oxide, lithium nickel manganese oxide, lithium nickel cobalt manganese oxide (such as $LiNi_{1/3}Co_{1/3}Mn_{1/3}O_2$ (also referred to as $NCM_{333}$), $LiNi_{0.5}Co_{0.2}Mn_{0.3}O_2$ (also referred to as $NCM_{523}$) At least one of $LiNi_{0.5}Co_{0.25}Mn_{0.25}O_2$ (also referred to as $NCM_{211}$), $LiNi_{0.6}Co_{0.2}Mn_{0.2}O_2$ (also referred to as $NCM_{622}$), $LiNi_{0.8}Co_{0.1}Mn_{0.1}O_2$ (also referred to as $NCM_{811}$), lithium nickel cobalt aluminum oxide (such as $LiNi_{0.85}Co_{0.15}Al_{0.05}O_2$), and its modified compounds. Examples of lithium containing phosphates with olivine structure may include, but are not limited to, at least one of Lithium iron phosphate (such as LiFePO4 (also referred to as LFP)), Lithium iron phosphate and carbon composites, Manganese(II) phosphate lithium phosphate (such as $LiMnPO_4$), Manganese(II) phosphate lithium phosphate and carbon composites, lithium manganese iron phosphate, lithium manganese iron phosphate and carbon composites.

In some embodiments, the positive electrode active material layer may also optionally include an adhesive. As an example, the adhesive can include at least one of polyvinylidene fluoride (PVDF), polytetrafluoroethylene (PTFE), vinylidene fluoride tetrafluoroethylene propylene terpolymer, vinylidene fluoride Hexafluoropropylene tetrafluoroethylene terpolymer, tetrafluoroethylene Hexafluoropropylene copolymer and fluoroacrylate resin.

In some embodiments, the positive electrode active material layer may also optionally include a conductive agent. As an example, the conductive agent can include at least one of superconducting carbon, acetylene black, carbon black, Ketjen black, carbon dots, carbon nanotubes, graphene and carbon nanofibers.

In some embodiments, the positive electrode sheet can be prepared by dispersing the above components used to prepare the positive electrode sheet, such as positive active materials, conductive agents, adhesives and any other components into solvents (such as N-Methyl-2-pyrrolidone) to form positive paste; After coating the positive electrode paste on the positive electrode current collector, drying, cold pressing, and other processes, the positive electrode plate can be obtained.

[Seperator]

In some embodiments, the secondary battery also includes a seperator. There are no special restrictions on the types of seperators in the present application, and any well-known porous structure seperator with good chemical and mechanical stability can be selected.

In some embodiments, the material of the seperator can be selected from at least one of glass fiber, non-woven fabric, polyethylene, polypropylene and polyvinylidene fluoride. The seperator can be a single layer thin film or a multi-layer composite thin film without special limitations. When the seperator is a multi-layer composite film, the materials of each layer can be the same or different without special restrictions.

In some embodiments, the positive electrode plate, negative electrode plate, and seperator can be made into Electrode assembly through winding or lamination processes.

[Electrolyte]

The electrolyte plays a role in conducting ions between the positive and negative electrode plates. There are no specific restrictions on the types of electrolytes in the present application, and you can choose according to your needs. For example, the electrolyte can be liquid, gelled or all solid.

In some embodiments, the electrolyte uses an electrolyte solution. Electrolyte solution includes electrolyte salts and solvents.

In some embodiments, the electrolyte salt can be at least one selected from the group consisting of Lithium hexafluorophosphate, Lithium tetrafluoroborate, Lithium perchlorate, lithium hexafluoroarsenate, lithium difluorosulfonate Imide, lithium bis trifluoromethanesulfonate Imide, Lithium triflate, lithium Difluorophosphoric acid, Lithium borate difluoroxalate, Lithium borate dioxalate, lithium difluorodioxalate phosphate and lithium tetrafluorooxalate phosphate.

In some embodiments, the solvent can be at least one selected from the group consisting of ethyl carbonate, propyl carbonate, methyl ethyl carbonate, diethyl carbonate, dimethyl carbonate, dipropyl carbonate, methyl propyl carbonate, ethylene propyl carbonate, butyl carbonate, fluoro ethyl carbonate, methyl formate, methyl acetate, ethyl acetate, propyl acetate, methyl propionate, ethyl propionate, propyl propanoate, methyl butyrate, ethyl butyrate, 1,4-butyrolactone, sulfolane at least one of dimethyl sulfone, methyl ethyl sulfone, and diethyl sulfone.

In some embodiments, the electrolyte solution may also optionally include additives. For example, additives can include negative electrode film forming additives, positive electrode film forming additives, and can also include additives that can improve certain battery performance, such as additives that improve battery overcharging performance, additives that improve battery high or low temperature performance, etc.

In some embodiments, the secondary battery may include an outer packaging. The outer packaging can be used to encapsulate the Electrode assembly and electrolytes mentioned above.

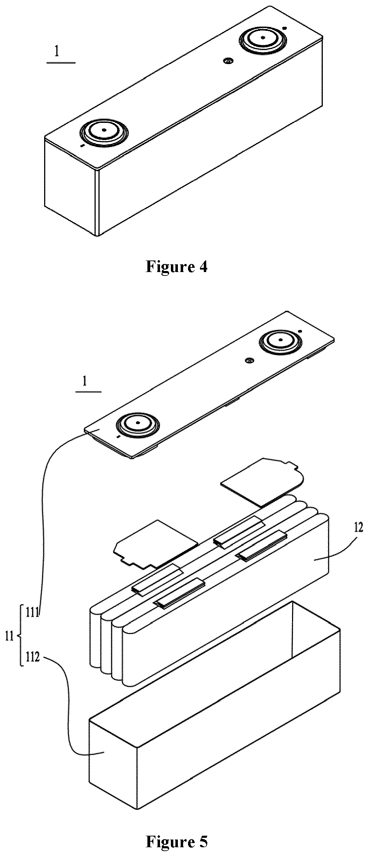

In some embodiments, the outsourcing of the secondary battery can be a hard shell, such as a hard plastic shell, aluminum shell, steel shell, etc. The outer packaging of the secondary battery can also be a soft bag, such as a bag type soft bag. The material of the soft bag can be plastic. As plastic, polypropylene, polybutylene terephthalate and Polybutylene succinate can be listed. There are no special restrictions on the shape of secondary batteries in the present application, which can be cylindrical, square, or any other shape. For example, Figures 4 and 5 are examples of a square structured secondary battery 1.

In some embodiments, secondary battery 1 includes outer packaging 11. The outer packaging 11 includes the top cover assembly 111 and the housing 112. The positive electrode plate, negative electrode plate, and seperator form an electrode assembly 12 that is housed in the housing 112, and the housing 112 also contains electrolyte. The positive or negative electrode plate includes the electrode ear. During the charging and discharging process of secondary battery 1, active ions are inserted and removed back and forth between the positive and negative electrode plates. The electrolyte plays a role in conducting ions between the positive and negative electrode plates. The seperator is set between the positive and negative electrode plates, mainly to prevent short circuits between the positive and negative electrodes, and to allow active ions to pass through. Specifically, the secondary battery 1 can be a coiled or laminated battery, such as a lithium ion battery and a Sodium-ion battery, but is not limited thereto.

Optionally, the housing 112 may include a bottom plate and a side plate connected to the bottom plate, which are enclosed to form a housing chamber. The shell 112 has an opening connected to the receiving cavity, and the top cover component 111 can cover the opening to close the receiving cavity. The positive electrode plate, negative electrode plate, and seperator can be formed into electrode assembly 12 through winding or stacking processes. The electrode assembly 12 is encapsulated in a receiving cavity. The electrolyte is immersed in electrode assembly 12. The number of Electrode assembly 12 contained in secondary battery 1 can be one or more, and technicians in this field can choose according to specific actual needs.

In some embodiments, secondary battery 1 can be assembled into a battery. The battery can be a battery module or a battery included. For example, the number of secondary batteries 1 contained in the battery module can be one or more, and the specific number can be selected by those skilled in the art based on the application and capacity of the battery module.

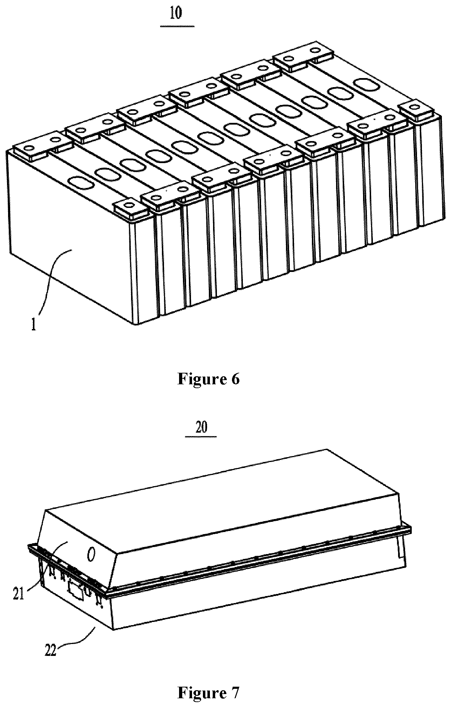

Figure 6 is an example of a battery module 10. Referring to Figure 6, in the battery module 10, multiple secondary batteries 1 can be arranged in sequence along the length direction of the battery module 10. Of course, it can also be arranged in any other way. Further, the multiple secondary batteries 1 can be fixed with fasteners. Optionally, the battery module 10 may also include a housing with accommodating space, in which multiple secondary batteries 1 are accommodated.

In some embodiments, the above-mentioned battery module 10 can also be assembled into a battery pack, and the number of battery modules 10 contained in the battery pack can be one or more. Technicians in this field can choose the specific number based on the application and capacity of the battery pack. Of course, the battery pack can also be directly composed of multiple secondary batteries 1.

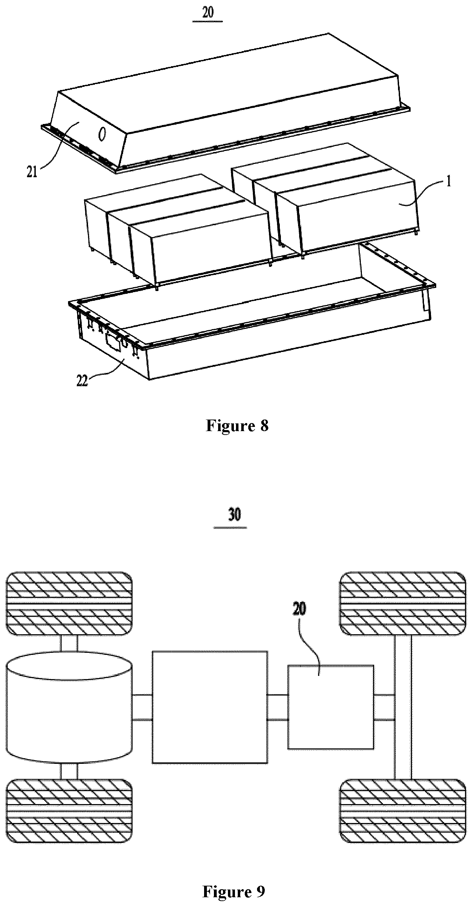

Figures 7 and 8 are battery packs 20 as an example. Referring to Figures 7 and 8, the battery pack 20 can include a battery box and multiple battery modules 10 arranged in the battery box. The battery box includes an upper box 21 and a lower box 22. The upper box 21 can cover the lower box 22 and form a closed space for accommodating the battery module 10. Multiple battery modules 10 can be arranged in any way in the battery box.

In addition, the present application also provides an electrical device, which includes at least one of the secondary batteries, battery modules, or battery packs provided in the present application. Secondary batteries, battery modules, or battery packs can be powered by the power supply of the power supply device or the energy storage unit of the power supply device. Electric devices can include, but are not limited to, mobile devices (such as mobile phones, laptops, etc.), electric vehicles (such as Battery electric vehicle, hybrid electric vehicles, plug-in hybrid electric vehicles, electric bicycles, electric scooters, electric golf carts, electric trucks, etc.), electric and pneumatic trains, ships and satellites, energy storage systems, etc. As an electrical device, secondary batteries, battery modules, or battery packs can be selected based on their usage needs.

Figure 9 is an example of an electrical device 30. The electric device 30 is a Battery electric vehicle, a hybrid electric vehicle, or a plug-in hybrid electric vehicle, etc. In order to satisfy the high power and energy density requirements of the 30 pairs of secondary batteries in the electrical device, battery packs or battery modules can be used. Another example of a device could be a phone, tablet, laptop, etc. This device usually requires lightness and thinness, and can use a secondary battery as the power source.

## Examples

The following describes embodiments of the present application. The embodiments described below are exemplary and are only intended to explain the present application, and cannot be understood as limitations to the present application. If the specific technology or conditions are not specified in the implementation example, the technology or conditions described in the literature in this field or the product manual shall be followed. The reagents or instruments used without specifying the manufacturer are all conventional products that can be obtained through market procurement.

Example 1

1. Preparation of positive electrode plate

A thickness of 8 $\mu$m aluminum foil serving as the positive electrpde current collector was used. The positive active material $LiNi_{1/3}Co_{1/3}Mn_{1/3}O_2$ ($NCM_{333}$), conductive carbon black and binder polyvinylidene fluoride (PVDF) were fully stirred and mixed in an appropriate amount of N-Methyl-2-pyrrolidone (NMP) solvent at a weight ratio of 93:2:5 to form a uniform positive electrode paste; and the positive electrode paste was applied to the surface of the positive electrode current collector, after drying and other processes, the positive electrode plate was obtained.

2. Preparation of negative electrode plate

2.1 Preparation of negative electrode active materials

The hard carbon containing a porous carbon skeleton was placed in the heating chamber of a vapor deposition furnace, and a vacuum pump was used to extract the vacuum from the heating chamber to a relative vacuum degree of from 100Pa to 800Pa.

The heating chamber was injected with nitrogen gas, after the chamber was filled with nitrogen gas, a gas containing silicon precursor was introduced into the heating chamber. The gas containing silicon precursor had a gas flow ratio of 5:1 to the protective gas.

The heating chamber was heated to 600°C, with protecting for 5 hours and maintainning positive pressure in the vapor deposition furnace; the gas containing silicon precursor was decomposed into silicon nanoparticles and deposited on the pores and/or surfaces of hard carbon, resulting in a silicon carbon composite.

After the insulation of the heating chamber is completed, the flow of gas containing the silicon precursor was stopped, allowing the silicon nanoparticles to naturally cool, and then the flow of nitrogen was stopped.

2.2 Preparation of negative electrode plate

The Negative electrode active material (silicon carbon complex), conductive carbon black, carboxymethyl cellulose sodium (CMC) as a thickening agent, and styrene-butadiene-rubber emulsion (SBR) as anadhesive are fully stirred and mixed in appropriate deionized water at the weight ratio of 96.5:1.0:1.0:1.5 to form a uniform negative paste; the negative electrode paste was applied onto the negative electrode current collector, after drying and other processes, the negative electrode plate was obtained.

3. Preparation of electrolyte solution

Ethylene carbonate (EC), methyl ethyl carbonate (EMC) and diethyl carbonate (DEC) were mixed in a volume ratio of 1:1:1 to obtain an organic solvent, and then the fully dried lithium salt $LiPF_6$ was dissolved in the mixed organic solvent to prepare an electrolyte with a concentration of 1mol/L.

4. Preparation of secondary batteries

The positive electrode plate, seperator (PP/PE/PP composite film), and negative electrode plate were sequentially stacked, then wound into a battery cell and placed in a packaging shell. The above electrolyte was injected into the battery cell, and then sealed, stood, hot and cold pressed, and formed to obtain a secondary battery.

Examples 2 to 11

The praparaion according to Exapmple 1 was repeated, except that the distribution of the mass percentage content of carbon and silicon elements in the silicon carbon composite was different. In order to satisfy the distribution of the mass percentage content of carbon and silicon elements, different embodiments could use negative electrode active materials with different particle size distributions, such as hard carbon with different particle sizes Dv50 or Spin.

Example 12

The praparaion according to Exapmple 1 was repeated, except that Example 12 used non porous hard carbon as the carbon-based particles.

Example 13

The praparaion according to Exapmple 1 was repeated, except that Example 13 used porous graphite as the carbon matrix particle.

Example 14

The praparaion according to Exapmple 1 was repeated, except that the surface of the silicon carbon composite in Example 14 is not coated with a conductive layer.

Examples 15 to 18

The praparaion according to Exapmple 1 was repeated, except that Examples 15 to 18 use hard carbon with different pore sizes and porosity.

Example 19 and Example 20

The praparaion according to Exapmple 1 was repeated, except that Example 19 and Example 20 used silicon nanoparticles with different particle sizes.

Examples 21 to 24

The praparaion according to Exapmple 1 was repeated, except that Examples 21 to 24 used different thicknesses of conductive layers.

Example 25 and Example 26

The praparaion according to Exapmple 1 was repeated, except that Examples 25 to 26 used different materials for the conductive layer.

Example 27 Example 31

The praparaion according to Exapmple 1 was repeated, except that at least one of the particle size Dv50 and particle size distribution spin in Example 27 and Example 31 was different.

Comparative Examples 1 to 2

The praparaion according to Exapmple 1 was repeated, except that the distribution of the mass percentage content of carbon and silicon elements in the silicon carbon composite was different. In order to satisfy the distribution of the mass percentage content of carbon and silicon elements, different embodiments coudd use negative electrode active materials with different particle size distributions, such as hard carbon with different particle sizes Dv50 or Spin.

Comparative Example 3

The praparaion according to Exapmple 1 was repeated, except that the negative electrode active material used porous hard carbon, in which no silicon nanoparticles were deposited and no conductive layer was coated.

The implementation example and the parameters of the proportional negative electrode active material are shown in Tables 1 to 7.

Table 1

| Items | Carbon-based particles | $A_2$ | $B_2$ | $A_2/B_2$ | $A_1$ | $B_1$ | $B_1/A_1$ | A | B | A/B |
|---|---|---|---|---|---|---|---|---|---|---|
| Example 1 | Hard carbon | 50.7% | 48.3% | 1.05 | 50.6% | 40.5% | 0.8 | 50.6% | 41.5% | 1.2 |
| Example 2 | Hard carbon | 66.1% | 33.2% | 2.00 | 45.1% | 45.0% | 1.0 | 47.7% | 44.3% | 1.1 |
| Example 3 | Hard carbon | 74.3% | 24.8% | 3.00 | 41.4% | 49.7% | 1.2 | 46.6% | 45.4% | 1.0 |
| Example 4 | Hard carbon | 90.2% | 9.1% | 10.00 | 36.4% | 54.6% | 1.5 | 48.9% | 43.1% | 1.1 |
| Example 5 | Hard carbon | 97.9% | 1.9% | 50.00 | 26.1% | 64.9% | 2.5 | 57.1% | 34.9% | 1.6 |
| Example 6 | Hard carbon | 51.3% | 47.2% | 1.09 | 45.2% | 44.9% | 1.0 | 46.1% | 45.9% | 1.0 |
| Example 7 | Hard carbon | 54.5% | 44.3% | 1.23 | 45.1% | 44.8% | 1.0 | 52.2% | 40.1% | 1.3 |
| Example 8 | Hard carbon | 63.2% | 35.3% | 1.79 | 45.3% | 44.9% | 1.0 | 60.1% | 30.1% | 2.0 |
| Example 9 | Hard carbon | 78.2% | 20.4% | 3.83 | 45.6% | 45.0% | 1.0 | 70.1% | 23.4% | 3.0 |
| Example 10 | Hard carbon | 83.2% | 15.6% | 5.33 | 45.4% | 44.8% | 1.0 | 76.5% | 15.3% | 5.0 |
| Example 11 | Hard carbon | 50.8% | 48.0% | 1.06 | 44.7% | 45.2% | 1.0 | 48.4% | 53.8% | 0.9 |
| Compartive Example 1 | Hard carbon | 44.0% | 54.9% | 0.80 | 75.8% | 15.2% | 0.2 | 61.8% | 30.2% | 2.0 |

(continued)

| Items | Carbon-based particles | $A_2$ | $B_2$ | $A_2/B_2$ | $A_1$ | $B_1$ | $B_1/A_1$ | A | B | A/B |
|---|---|---|---|---|---|---|---|---|---|---|
| Compartive Example 2 | Hard carbon | 96.0% | 1.2% | 80.00 | 15.2% | 76.1% | 5.0 | 64.3% | 27.7% | 2.3 |

Table 2

| Items | Carbon-based particles | | | Silicon nanoparticles | Conductive layer | |
|---|---|---|---|---|---|---|
| | Material | Pore size (nm) | Porosity % | D particle size (nm) | Material | Thickness (nm) |
| Example 1 | Hard carbon | 25.1 | 49.9 | 5.1 | Carbon | 3.1 |
| Example 12 | Hard carbon | None | None | 5.3 | Carbon | 3.2 |
| Example 13 | Graphite | None | None | 5.4 | Carbon | 3.0 |
| Example 14 | Hard carbon | 25.2 | 49.6 | 5.1 | None | None |
| Compartive Example 3 | Hard carbon | 25.1 | 49.9 | None | None | None |

Table 3

| Items | $A_2$ | $B_2$ | $A_2/B_2$ | $A_1$ | $B_1$ | $B_1/A_1$ | A | B | A/B |
|---|---|---|---|---|---|---|---|---|---|
| Example 1 | 50.7% | 48.3% | 1.05 | 50.6% | 40.5% | 0.8 | 50.6% | 41.5% | 1.2 |
| Example 12 | 90.3% | 8.9% | 10 | 48.1% | 44.6% | 1.0 | 53.4% | 40.2% | 1.3 |
| Example 13 | 89.3% | 9.7% | 9 | 47.9% | 44.9% | 1.0 | 53.1% | 40.5% | 1.3 |
| Example 14 | 50.8% | 48.2% | 1.05 | 48.7% | 44.2% | 1.0 | 52.9% | 40.3% | 1.3 |
| Compartive Example 3 | None | None | None | None | None | None | None | None | None |

Table 4

| Items | Carbon-based particles | | | Silicon nanoparticles | Conductive layer | |
|---|---|---|---|---|---|---|
| | Material | Pore size (nm) | Porosity % | D particle size (nm) | Material | Thickness ($\mu$m) |
| Example 1 | Hard carbon | 25.1 | 49.9 | 5.1 | Carbon | 3.1 |
| Example 15 | Hard carbon | 1.1 | 40.0 | 4.9 | Carbon | 3.1 |
| Example 16 | Hard carbon | 50.2 | 55.0 | 5.2 | Carbon | 2.9 |
| Example 17 | Hard carbon | 50.1 | 60.0 | 5.1 | Carbon | 3.0 |
| Example 18 | Hard carbon | 201.2 | 70.0 | 5.3 | Carbon | 3.2 |
| Example 19 | Hard carbon | 25.1 | 49.9 | 9.8 | Carbon | 3.1 |
| Example 20 | Hard carbon | 25.1 | 49.9 | 2.8 | Carbon | 3.0 |
| Example 21 | Hard carbon | 25.2 | 49.6 | 5.1 | Carbon | 2.5 |
| Example 22 | Hard carbon | 25.2 | 49.6 | 5.1 | Carbon | 3.5 |
| Example 23 | Hard carbon | 25.2 | 49.6 | 5.1 | Carbon | 1.5 |

(continued)

| Items | Carbon-based particles | | | Silicon nanoparticles | Conductive layer | |
|---|---|---|---|---|---|---|
| | Material | Pore size (nm) | Porosity % | D particle size (nm) | Material | Thickness ($\mu$m) |
| Example 24 | Hard carbon | 25.2 | 49.6 | 5.1 | Carbon | 2.0 |
| Example 25 | Hard carbon | 25.2 | 49.6 | 5.1 | Polyaniline | 3.0 |
| Example 26 | Hard carbon | 25.2 | 49.6 | 5.1 | Polypyrrole | 2.9 |

Table 5

| Items | $A_2$ | $B_2$ | $A_2/B_2$ | $A_1$ | $B_1$ | $B_1/A_1$ | A | B | A/B |
|---|---|---|---|---|---|---|---|---|---|
| Example 1 | 50.7% | 48.3% | 1.05 | 50.6% | 40.5% | 0.8 | 50.6% | 41.5% | 1.2 |
| Example 15 | 66.2% | 32.9% | 2.01 | 46.8% | 44.8% | 1.0 | 53.2% | 39.9% | 1.3 |
| Example 16 | 65.9% | 33.4% | 1.97 | 45.9% | 45.2% | 1.0 | 52.9% | 40.1% | 1.3 |
| Example 17 | 66.0% | 33.1% | 1.99 | 46.4% | 45.1% | 1.0 | 53.0% | 40.3% | 1.3 |
| Example 18 | 66.3% | 33.2% | 2.00 | 46.1% | 45.3% | 1.0 | 52.8% | 40.2% | 1.3 |
| Example 19 | 65.7% | 33.2% | 1.98 | 46.3% | 44.7% | 1.0 | 53.1% | 39.5% | 1.3 |
| Example 20 | 65.4% | 33.5% | 1.95 | 46.2% | 44.5% | 1.0 | 52.9% | 39.4% | 1.3 |
| Example 21 | 50.8% | 48.2% | 1.05 | 48.7% | 44.2% | 1.1 | 52.9% | 40.3% | 1.3 |
| Example 22 | 50.8% | 48.2% | 1.05 | 48.7% | 44.2% | 1.1 | 52.9% | 40.3% | 1.3 |
| Example 23 | 50.8% | 48.2% | 1.05 | 48.7% | 44.2% | 1.1 | 52.9% | 40.3% | 1.3 |
| Example 24 | 50.8% | 48.2% | 1.05 | 48.7% | 44.2% | 1.1 | 52.9% | 40.3% | 1.3 |
| Example 25 | 50.8% | 48.2% | 1.05 | 48.7% | 44.2% | 1.1 | 52.9% | 40.3% | 1.3 |
| Example 26 | 50.8% | 48.2% | 1.05 | 48.7% | 44.2% | 1.1 | 52.9% | 40.3% | 1.3 |

Table 6

| Items | Negative Electrode Active Material | | | | |
|---|---|---|---|---|---|
| | Dv50($\mu$m) | Dv10($\mu$m) | Dv90($\mu$m) | (Dv90-Dv10)/Dv50 | BET (m$^2$/g) |
| Example 1 | 8.1 | 3.1 | 13.3 | 1.3 | 3.4 |
| Example 27 | 5.0 | 2.7 | 9.3 | 1.3 | 3.4 |
| Example 28 | 11.0 | 3.1 | 17.9 | 1.3 | 3.6 |
| Example 29 | 8.0 | 2.6 | 13.5 | 1.4 | 3.4 |
| Example 30 | 8.1 | 3.1 | 11.5 | 1.0 | 3.5 |
| Example 31 | 7.9 | 3.5 | 10.2 | 0.8 | 3.4 |

Table 7

| Items | $A_2$ | $B_2$ | $A_2/B_2$ | $A_1$ | $B_1$ | $B_1/A_1$ | A | B | A/B |
|---|---|---|---|---|---|---|---|---|---|
| Example 1 | 50.7% | 48.3% | 1.05 | 50.6% | 40.5% | 0.8 | 50.6% | 41.5% | 1.2 |
| Example 27 | 65.9% | 32.9% | 2.00 | 45.7% | 45.3% | 1.0 | 52.8% | 39.2% | 1.3 |
| Example 28 | 66.2% | 32.7% | 2.02 | 45.6% | 45.2% | 1.0 | 53.1% | 39.4% | 1.3 |

(continued)

| Items | $A_2$ | $B_2$ | $A_2/B_2$ | $A_1$ | $B_1$ | $B_1/A_1$ | A | B | A/B |
|---|---|---|---|---|---|---|---|---|---|
| Example 29 | 66.3% | 32.5% | 2.04 | 45.8% | 45.1% | 1.0 | 52.6% | 39.4% | 1.3 |
| Example 30 | 66.2% | 32.6% | 2.03 | 45.6% | 45.2% | 1.0 | 52.8% | 39.3% | 1.3 |
| Example 31 | 66.3% | 32.7% | 2.03 | 45.9% | 45.2% | 1.0 | 52.5% | 39.2% | 1.3 |

In Tables 1 to 7, the regulation process of the porous structure of carbon-based particles is illustrated by taking carbon-based particles as hard carbon as an example: biomass is used as a carbon source to break biomass, and biomass can be used in one or more of coconut shells, bark, and fruit kernels. Clean the crushed biomass with Mineral acid, and Mineral acid can use one or more of sulfuric acid, hydrochloric acid and hydrofluoric acid. The concentration of Mineral acid is 1mol/L~5mol/L, and the pickling time is from 0.5h to 2h. After pickling, the biomass is first washed with deionized water to remove residual acid, and then pre carbonized in an inert atmosphere. Inert gases can be selected from one or more of nitrogen, argon, and helium. The pre carbonization temperature is between 400°C and 500°C, and the pre carbonization time is between 2h and 5h. Carbonize the pre carbonized biomass at high temperature to obtain porous carbon materials. The carbonization temperature is from 800°C to 1600°C, and the carbonization time is 2-4 hours.

**Performance testing**

Testing of negative electrode active materials

1. Characterization of silicon and carbon element distribution in carbon-silicon composites

Energy spectrum ion polishing section element analysis, according to the GB-T17359-2012 testing standard, was used to test the element distribution of the particle section.

2. Measurement of Silicon Element Content in Carbon-silicon composite

Inductively coupled plasma (ICP) was used to determine the silicon content. Specifically, the carbon-silicon composite was taken as a sample, and the sample was digested with aqua regia and HF hydrofluoric acid. The 15 minute digested solution and the fully digested solution were used for ICP testing. The silicon content in the 45 minute digested solution was the "peripheral region" of the carbon-silicon composite. The difference in silicon content between the fully digested and 1-hour solution is the silicon content in the central area of the carbon silicon complex.

3. Carbon element content testing in carbon-silicon composites

The infrared absorption method for carbon sulfur content analysis was tested according to stand GB/T20123-2006. Specifically, taking the carbon-silicon composite as a sample, and the carbon content at 20 minutes of testing was the carbon content at the "peripheral area of the carbon-silicon composite". The difference between the carbon content at 20 minutes of testing and the end of testing was the carbon content at the "peripheral area of the carbon-silicon composite".

4. Short diameter testing of carbon-silicon composites

The short diameter r was measured based on the triaxial characterization method as follows: Measuring the short diameter r on the plane projection of the carbon-silicon composite.

5. Determination of Dv10, Dv90, and Dv50 for negative electrode active materials

Using a laser diffraction particle size distribution measuring instrument (Malvern Mastersizer 3000), based on the particle size distribution laser diffraction method GB/T19077-2016, the particle size distribution was measured to obtain Dv10, Dv90, Dv50, and (Dv90 Dv10)/Dv50 was calculated.

6. BET measurement of specific surface area of negative electrode active materials

The gas adsorption method was used to test the specific surface area according to the GB/T19587-2017 testing standard. Specifically, taking the negative electrode active material as a sample, immersing the sample tube in liquid nitrogen at -196°C, and measuring the adsorption amount of nitrogen on the solid surface at different pressures between 0.05 and 0.30. Based on the BET multi-layer adsorption theory and its formula, calculating the single molecular layer adsorption amount of the sample, and then calculating the specific surface area of the negative electrode active material.

The calculation formula for BET is as follows:

$$\frac{P/P_0}{n_a(1 - P/P_0)} = \frac{1}{n_m C} + \frac{C - 1}{n_m C} \cdot \frac{P}{P_0}$$

in the formula, $n_a$-the amount of adsorbed gas, in mol/g; $P/P_0$-relative pressure; $N_m$-Single molecular layer adsorption capacity; C represents a revised parameter used to limit the number of adsorption layers on the adsorbent surface.

7. Determination of porosity of carbon-based particles

According to GB/T24586, the gas displacement method was used for measurement. Porosity P=(V1-V2)/V1 * 100%, where V1 is the apparent volume of the sample and V2 is the true volume of the sample.

8. Determination of pore size of carbon-based particles

The gas adsorption method was used to test the pore size according to the GB/T19587-2017 and GB/T21650.2-2008 testing standards. The specific details are as follows: taking a silicon carbon composite as a sample, immersing the sample tube in liquid nitrogen at -196°C, and adsorbing nitrogen on the material to be tested at a relative pressure of 0-1. The pore size distribution of the porous material was characterized based on the relationship between the volume of each pore size and the corresponding partial pressure.

9. Determination of particle size D of silicon nanoparticles

According to the JIS/K0131-1996 testing standard, the XRD pattern of the sample was tested. Based on the XRD pattern of the sample, the half peak width of the Si (111) crystal plane diffraction peak β and diffraction angle θ was taken into Debye-Scherrer formula, to obtain the particle size of nano silicon particles . The Debye-Scherrer formula is as follows: Dhkl = k · λ/ ( β Cos θ),

in the formula, Dhkl represents the particle size of nano silicon particles, in nm; K represents the Scherrer constant, 0.89; λ Indicates the wavelength of the incident X-ray, 0.15406 nm; β represents the half peak width of the diffraction peak, in rad; and θ represents the diffraction angle in degrees.

10. Determination of the thickness of conductive layers

Using the scanning electron microscope method, the ion polished cross-sectional morphology of the sample was tested according to the JY/T010-1996 testing standard. The thickness of the conductive coating layer outside the material body was measured based on the cross-sectional morphology.

Cyclic performance testing of secondary batteries

1. Normal temperature cycling performance test of secondary batteries

The test condition was at room temperature. Charging the secondary battery at a rate of 0.5C and discharging it at a rate of 0.5C, and conducting a full charge discharge cycle test until the capacity of the secondary battery decays to 80% of the initial capacity. Stoping the test and recording the number of cycles.

At room temperature, letting the secondary battery stand for 30 minutes, then charging it at a constant current of 0.5C to a voltage of 4.2V, further charging it at a constant voltage of 4.2V to a current of 0.05C, letting it stand for 5 minutes, and then discharging it at a constant current of 0.5C to a voltage of 2.8V. This is one charging and discharging cycle, and the discharge capacity is the initial discharge capacity of the battery. Conducting 1000 cycling charging/discharging tests according to the above method, and recording the discharge capacity of the second battery after the 1000th cycle.

Capacity retention rate after 1000 cycles of secondary battery (%) = (discharge capacity of the 1000th cycle/discharge capacity of the initial cycle) × 100%.

2. Cyclic performance testing of secondary batteries at 45°C

The test condition was 45 °C. Charging the secondary battery at a rate of 1C and discharging it at a rate of 1C, and conducting a full charge discharge cycle test until the capacity of the secondary battery decays to 80% of the initial capacity. Stopping the test and record the number of cycles.

At 45°C, letting the secondary battery stand for 30 minutes, then charging it at a constant current of 1C to a voltage of 4.2V, further charging it at a constant voltage of 4.2V to a current of 0.05C, letting it stand for 5 minutes, and then discharging it at a constant current of 1C to a voltage of 2.8V. This is one charging and discharging cycle, and the discharge capacity is the initial discharge capacity of the battery. Conducting 1000 cycling charging/discharging tests according to the above method, and recording the discharge capacity of the second battery after the 1000th cycle.

Capacity retention rate after 1000 cycles of secondary battery (%) = (discharge capacity of the 1000th cycle/discharge capacity of the initial cycle) × 100%.

**Test results**

The role of the negative electrode active material in improving the cycling performance of the secondary battery in the present application is shown in Tables 8 to 11.

Table 8

| Items | 25°C, cycle to 80% capacity retention rate, cls (circles) | 45°C, cycle to 80% capacity retention rate, cls (circles) |
| --- | --- | --- |
| Example 1 | 1200cls | 910cls |
| Example 2 | 1350cls | 980cls |
| Example 3 | 1380cls | 990cls |
| Example 4 | 1195cls | 900cls |
| Example 5 | 1150cls | 890cls |
| Example 6 | 1220cls | 910cls |
| Example 7 | 1250cls | 910cls |
| Example 8 | 1280cls | 920cls |
| Example 9 | 1270cls | 920cls |
| Example 10 | 1050cls | 810cls |
| Example 11 | 1020cls | 810cls |
| Comparative Example 1 | 950cls | 700cls |
| Comparative Example 2 | 900cls | 650cls |

From Table 8, it can be seen that compared to the ratio 1 and ratio 2, the cycling performance of the secondary battery is better when the silicon nanoparticles are uniformly deposited on the carbon skeleton in Examples 1 to 11; By regulating $0.8 \leq B_1/A_1 \leq 2.5$, especially $1 \leq B_1/A_1 \leq 1.5$, silicon nanoparticles can be uniformly deposited in the pores of the carbon skeleton. During the cycling process of the secondary battery, the expansion of silicon nanoparticles can be effectively suppressed, thereby improving the structural stability of the negative electrode active material and improving the cycling performance of the secondary battery. Furthermore, regulating $1.05 \leq A_2/B_2 < 50$, especially $1.05 \leq A_2/B_2 < 3$, can further regulate the uniform deposition of silicon nanoparticles on the overall structure of the carbon skeleton, thereby further improving the cycling performance of secondary batteries. Furthermore, regulating $1 \leq A/B \leq 3$, especially

$1.3 \le A/B \le 2$, can further regulate the uniform deposition of silicon nanoparticles on the overall structure of the carbon skeleton, thereby further improving the cycling performance of secondary batteries.

Table 9

| Items | 25°C, cycle to 80% capacity retention rate, cls (circles) | 45°C, cycle to 80% capacity retention rate, cls (circles) |
|---|---|---|
| Example 1 | 1200cls | 910cls |
| Example 12 | 1080cls | 820cls |
| Example 13 | 1080cls | 820cls |
| Example 14 | 1150cls | 870cls |
| Comparative Example 3 | 200cls | 50cls |

From Table 9, it can be seen that for the proportion 3 where silicon nanoparticles were not deposited on hard carbon, the overall cycling performance was relatively poor. Compared to the ratio 3, in Examples 12 to 13, depositing silicon nanoparticles on porous hard carbon can improve the structural stability of the negative electrode active material to a certain extent; Example 1: Depositing silicon nanoparticles in porous hard carbon can significantly improve the structural stability of the negative electrode active material, thereby improving the cycling performance of the secondary battery; Compared to Example 14, Example 1 forms a conductive layer on the surface of the silicon carbon composite, which can further improve the conductivity of the secondary battery.

Table 10

| Items | 25°C, cycle to 80% capacity retention rate, cls (circles) | 45°C, cycle to 80% capacity retention rate, cls (circles) |
|---|---|---|
| Example 1 | 1200cls | 910cls |
| Example 15 | 1210cls | 910cls |
| Example 16 | 1200cls | 900cls |
| Example 17 | 1200cls | 910cls |
| Example 18 | 1100c1s | 870cls |
| Example 19 | 1190cls | 910cls |
| Example 20 | 1220cls | 910cls |
| Example 21 | 1200cls | 900cls |
| Example 22 | 1200cls | 930cls |
| Example 23 | 1140cls | 820cls |
| Example 24 | 1140cls | 830cls |
| Example 25 | 1210cls | 900cls |
| Example 26 | 1220cls | 900cls |

From Table 10, it can be seen that Example 1, Example 15, and Example 18 can adjust the deposition effect of silicon nanoparticles by adjusting the pore size and porosity of hard carbon, thereby regulating the structural stability of the negative electrode active material.

In Example 19 and Example 20, the particle size of silicon nanoparticles can be adjusted to appropriately regulate the performance of silicon carbon composites.

Examples 21 to 26 regulate the conductive layer of the negative electrode active material, which can improve the conductivity of the negative electrode active material.

Table 11

| Items | 25°C, cycle to 80% capacity retention rate, cls (circles) | 45°C, cycle to 80% capacity retention rate, cls (circles) |
|---|---|---|
| Example 1 | 1200cls | 910cls |
| Example 27 | 1200cls | 950cls |
| Example 28 | 1200cls | 890cls |
| Example 29 | 1200cls | 910cls |
| Example 30 | 1260cls | 930cls |
| Example 31 | 1280cls | 950cls |

From Table 11, it can be seen that Example 27 to Example 31 can also improve the performance of the negative electrode active material by regulating its particle size, thereby improving the cycling performance of the secondary battery.

Although the present application has been described with reference to preferred embodiments, various improvements can be made and components can be replaced with equivalents without departing from the scope of the present application. Especially, as long as there is no structural conflict, the various technical features mentioned in each embodiment can be combined in any way. The present application is not limited to the specific embodiments disclosed in the text, ut includes all technical solutions falling within the scope of the claims.

## Claims

1. A negative electrode active material, including a carbon-silicon composite comprising:

   a carbon-based particles having a carbon skeleton;
   a silicon nanoparticles attached to the carbon skeleton of the carbon-based particles, wherein,
   in the peripheral area of the carbon-silicon composite, the mass percentage $A_1$ of carbon element in the carbon-silicon composite relative to the total mass of the carbon-silicon composite and the mass percentage $B_1$ of the silicon element in the carbon-silicon composite relative to the total mass of the carbon-silicon composite satisfy $0.8 \le B_1/A_1 \le 2.5$, and optionally, $1 \le B1/A1 \le 1.5$, wherein, the peripheral area of the carbon-silicon composite is an area extending within r/2 from the outer surface of the carbon-silicon composite towards the interior of the carbon-silicon composite, wherein r represents the short diameter of the carbon-silicon composite.

2. The negative electrode active material according to claim 1, wherein,
   in the central area of the carbon-silicon composite, the mass percentage content $A_2$ of the carbon element in the carbon-silicon composite relative to the total mass of the carbon-silicon composite and the mass percentage content $B_2$ of the silicon element in the carbon-silicon composite relative to the total mass of the carbon-silicon composite satisfy $1.05 \le A_2/B_2 \le 50$, and optionally, $1.05 \le A_2/B_2 \le 3$, wherein, the central area of the carbon silicon complex is the area within r/2 from the Centroid of the carbon silicon complex.

3. The negative electrode active material according to claim 1 or 2, wherein,

   the mass percentage content B of silicon element of the carbon silicon complex relative to the total mass of the carbon silicon complex has an increasing trend along the direction from the centroid of the carbon silicon complex to the outer surface of the carbon silicon complex;
   optionally, the mass percentage A of the carbon element in the carbon-silicon composite relative to the total mass of the carbon-silicon composite and the mass percentage B of the silicon element in the carbon-silicon composite relative to the total mass of the carbon-silicon composite also satisfy $1 \le A/B \le 3$, and further optionally, $1.3 \le A/B \le 2$.

4. The negative electrode active material according to any one of claims 1 to 3, wherein,
   the carbon-based particles include one or more of graphite, soft carbon, and hard carbon.

5. The negative electrode active material according to any one of claims 1 to 4, wherein,

the carbon skeleton is a porous carbon skeleton, and the silicon nanoparticles are located in the pores and/or surface of the porous carbon skeleton;
optionally, the porous carbon skeleton includes pores that run through the carbon skeleton; optionally, the pore size of the hole is from 1nm to 200nm; and optionally, the pore size of the hole ranges from 1nm to 50nm; optionally, the porosity of the porous carbon skeleton ranges from 40% to 70%, and further optionally, the porosity of the porous carbon skeleton ranges from 50% to 60%.

6. The negative electrode active material according to any one of claims 1 to 5, wherein, the particle size D of the silicon nanoparticles satisfies D ≤ 10nm.

7. The negative electrode active material according to any one of claims 1 to 6, wherein the negative electrode active material further comprises a conductive layer coated with the carbon-silicon composite.

8. The negative electrode active material according to claim 7, wherein, the thickness of the conductive layer is ≤ 3.5 $\mu$m, and optionally, the thickness of the conductive layer is from 2.5 $\mu$m to 3.3 $\mu$m.

9. The negative electrode active material according to claim 7 or 8, wherein,

the conductive layer includes a carbon layer and/or a conductive polymer layer;
optionally, the conductive polymer layer includes one or more of polyaniline, polypyrrole, polyacetylene, polythiophene, polyphenylene sulfide and polyparaphenylene.

10. The negative electrode active material according to any one of claims 1 to 9, wherein,

the average particle size Dv50 of the negative electrode active material satisfies 5 $\mu$m ≤ Dv50 ≤ 11 $\mu$m;
optionally, the average particle sizes Dv90, Dv10, and Dv50 of the negative electrode active material satisfy the following requirements: (Dv90 Dv10)/Dv50 ≤ 1.4.

11. The negative electrode active material according to any one of claims 1 to 10, wherein, the specific surface area BET of the negative electrode active material is BET ≤ 4m$^2$/g.

12. A method for preparing negative electrode active materials, comprising:

S100, providing gas containing silicon precursor to carbon-based particles having a carbon skeleton;
S200, generating silicon nanoparticles attached to the carbon skeleton from the silicon precursor by chemical vapor deposition, resulting in a carbon-silicon composite,
in the peripheral area of the carbon-silicon composite, the mass percentage A1 of the carbon element in the carbon-silicon composite relative to the total mass of the carbon-silicon composite and the mass percentage B1 of the silicon element in the carbon-silicon composite relative to the total mass of the carbon-silicon composite satisfy 0.8 ≤ B$_1$/A$_1$ ≤ 2.5, and optionally, 1 ≤ B$_1$/A$_1$ ≤ 1.5, wherein, the peripheral area of the carbon-silicon composite is an area extending within r/2 from the outer surface of the carbon-silicon composite towards the interior of the carbon-silicon composite.

13. The method according to claim 12, further comprising:
S300 forming a conductive layer on the silicon carbon composite.

14. A secondary battery, comprising the negative electrode active material according to any one of claims 1 to 11 or the negative electrode active material obtained by the method according to claim 12 or 13.

15. A battery module, comprising the secondary battery according to claim 14.

16. A battery pack, comprising the battery module according to claim 15.

17. An electrical device, comprising the secondary battery according to claim 14, the battery module according to claim 15, or the battery pack according to claim 16.

Providing gas containing silicon precursor to carbon-based particles having a carbon skeleton. ⌐S100

Generating silicon nanoparticles attached to the carbon skeleton from silicon precursors by chemical vapor deposition, resulting in a silicon carbon composite. ⌐S200

**Figure 1**

Providing gas containing silicon precursor to carbon-based particles having a carbon skeleton. ⌐S100

Generating silicon nanoparticles attached to the carbon skeleton from silicon precursors by chemical vapor deposition, resulting in a silicon carbon composite. ⌐S200

Formig a conductive layer on the silicon carbon composite. ⌐S300

**Figure 2**

Preparing carbon-based particles having porous carbon skeleton. ⌐S400

Providing gas containing silicon precursor to carbon-based particles having a carbon skeleton. ⌐S100

Generating silicon nanoparticles attached to the carbon skeleton from silicon precursors by chemical vapor deposition, resulting in a silicon carbon composite. ⌐S200

Formig a conductive layer on the silicon carbon composite. ⌐S300

**Figure 3**

Figure 4

Figure 5

10

Figure 6

20

Figure 7

20

**Figure 8**

30

**Figure 9**

## INTERNATIONAL SEARCH REPORT

| International application No. |
|---|
| **PCT/CN2022/094848** |

**A. CLASSIFICATION OF SUBJECT MATTER**

H01M4/38(2006.01)i;H01M4/587(2010.01)i

According to International Patent Classification (IPC) or to both national classification and IPC

**B. FIELDS SEARCHED**

Minimum documentation searched (classification system followed by classification symbols)

H01M

Documentation searched other than minimum documentation to the extent that such documents are included in the fields searched

Electronic data base consulted during the international search (name of data base and, where practicable, search terms used)

CNABS; CNTXT; DWPI; VEN; ENTXT; CNKI: 硅, 碳, 骨架, 短径, 表面, 中心, 含量, 气相沉积, 硅烷, silicon, carbon, framework, minor axis, surface, center, content, vapor deposition, silane

**C. DOCUMENTS CONSIDERED TO BE RELEVANT**

| Category* | Citation of document, with indication, where appropriate, of the relevant passages | Relevant to claim No. |
|---|---|---|
| X | CN 104577084 A (SHENZHEN BTR NEW ENERGY MATERIALS CO., LTD.) 29 April 2015 (2015-04-29) description, paragraphs 7-46 | 1-2, 4-15 |
| Y | CN 104577084 A (SHENZHEN BTR NEW ENERGY MATERIALS CO., LTD.) 29 April 2015 (2015-04-29) description, paragraphs 7-46 | 3 |
| Y | CN 114402456 A (SHANGHAI SHANSHAN TECH CO., LTD.) 26 April 2022 (2022-04-26) description, paragraphs 2-65 | 2-3, 7-11, 13, 16-17 |
| Y | CN 103262314 A (HITACHI CHEMICAL CO., LTD.) 21 August 2013 (2013-08-21) description, paragraphs 12-230 | 3 |
| A | US 2021276875 A1 (NEXEON LTD.) 09 September 2021 (2021-09-09) entire document | 1-17 |

☑ Further documents are listed in the continuation of Box C.    ☑ See patent family annex.

| | |
|---|---|
| \* Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **10 February 2023** | **17 February 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| Facsimile No. **(86-10)62019451** | Telephone No. |

Form PCT/ISA/210 (second sheet) (July 2022)

**INTERNATIONAL SEARCH REPORT**

| International application No. |
| --- |
| **PCT/CN2022/094848** |

**C. DOCUMENTS CONSIDERED TO BE RELEVANT**

| Category* | Citation of document, with indication, where appropriate, of the relevant passages | Relevant to claim No. |
| --- | --- | --- |
| X | LIU, Yuan et al. "Improving coulombic efficiency by confinement of solid electrolyte interphase film in pores of silicon/carbon composite"<br>*JOURNAL OF MATERIALS CHEMISTRY A,*<br>Vol. 1, No. 45, 17 September 2013 (2013-09-17),<br>ISSN: 2050-7488,<br>    p. 14075, left-hand column, paragraph 2 to p. 14078, right-hand column, paragraph 2, and figure 1 | 1, 4-6, 12, 14-15 |
| Y | LIU, Yuan et al. "Improving coulombic efficiency by confinement of solid electrolyte interphase film in pores of silicon/carbon composite"<br>*JOURNAL OF MATERIALS CHEMISTRY A,*<br>Vol. 1, No. 45, 17 September 2013 (2013-09-17),<br>ISSN: 2050-7488,<br>    p. 14075, left-hand column, paragraph 2 to p. 14078, right-hand column, paragraph 2, and figure 1 | 2-3, 7-11, 13, 16-17 |

Form PCT/ISA/210 (second sheet) (July 2022)

INTERNATIONAL SEARCH REPORT
Information on patent family members

International application No.

**PCT/CN2022/094848**

| Patent document cited in search report | | | Publication date (day/month/year) | Patent family member(s) | | | Publication date (day/month/year) |
|---|---|---|---|---|---|---|---|
| CN | 104577084 | A | 29 April 2015 | US | 2016211511 | A1 | 21 July 2016 |
| | | | | US | 10170753 | B2 | 01 January 2019 |
| | | | | JP | 2016134382 | A | 25 July 2016 |
| | | | | JP | 6367781 | B2 | 01 August 2018 |
| | | | | KR | 20160089858 | A | 28 July 2016 |
| | | | | KR | 101866004 | B1 | 08 June 2018 |
| CN | 114402456 | A | 26 April 2022 | | None | | |
| CN | 103262314 | A | 21 August 2013 | KR | 20130087609 | A | 06 August 2013 |
| | | | | KR | 101451538 | B1 | 15 October 2014 |
| | | | | US | 2013302675 | A1 | 14 November 2013 |
| | | | | US | 9614216 | B2 | 04 April 2017 |
| | | | | EP | 2650954 | A1 | 16 October 2013 |
| | | | | EP | 2650954 | B1 | 28 September 2016 |
| | | | | TW | 201230475 | A | 16 July 2012 |
| | | | | TWI | 536646 | B | 01 June 2016 |
| | | | | KR | 20140114874 | A | 29 September 2014 |
| | | | | KR | 102032104 | B1 | 15 October 2019 |
| | | | | WO | 2012077785 | A1 | 14 June 2012 |
| | | | | JP | 2012124115 | A | 28 June 2012 |
| | | | | JP | 2012124116 | A | 28 June 2012 |
| | | | | JP | 2012124117 | A | 28 June 2012 |
| | | | | JP | 2012124121 | A | 28 June 2012 |
| | | | | JP | 5682276 | B2 | 11 March 2015 |
| | | | | JP | 5691468 | B2 | 01 April 2015 |
| | | | | JP | 5691469 | B2 | 01 April 2015 |
| | | | | JP | 5903761 | B2 | 13 April 2016 |
| | | | | CN | 103262314 | B | 01 July 2015 |
| US | 2021276875 | A1 | 09 September 2021 | GB | 202012061 | D0 | 16 September 2020 |
| | | | | GB | 2597759 | A | 09 February 2022 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- GB 190772016 T
- GB 173592012 T
- GB 201232006 T
- GB 195872017 T
- GB 24586 T
- GB 2165022008 T